# EUROPEAN PATENT APPLICATION

(11) **EP 4 404 253 A1**
(43) Date of publication of application: **24.07.2024**
(21) Application number: 23212627.6
(22) Date of filing: 28.11.2023
(51) Int. Cl.: H01L 21/8234, H01L 21/8238, H01L 23/528

(54) **SEMICONDUCTOR DEVICE**

(30) Priority: 19.01.2023 KR 20230008274; 14.06.2023 KR 20230076258
(71) Applicant: Samsung Electronics Co., Ltd., Suwon-si, Gyeonggi-do 16677 (KR)
(72) Inventor: TANG, Hoyoung, 16677 Suwon-si, Gyeonggi-do (KR); KIM, Tae-Hyung, 16677 Suwon-si, Gyeonggi-do (KR); DO, Jungho, 16677 Suwon-si, Gyeonggi-do (KR)
(74) Representative: Kuhnen & Wacker Patent- und Rechtsanwaltsbüro PartG mbB

(57) **Abstract**

A semiconductor device including: first and second transistors on a substrate; an isolation transistor provided between the first and second transistors; a lower power line in a lower portion of the substrate; and a back-side gate contact penetrating the substrate and connected to the lower power line and a dummy gate electrode of the isolation transistor.

## Description

### CROSS-REFERENCE TO RELATED APPLICATIONS

This patent application claims priority to Korean Patent Application Nos. 10-2023-0008274 and 10-2023-0076258, filed on January 19, 2023 and June 14, 2023, respectively, in the Korean Intellectual Property Office, the disclosures of which are incorporated by reference herein in their entireties.

### Technical Field

The present disclosure relates to a semiconductor device, and in particular, to a semiconductor device with improved electrical characteristics and increased integration density.

### Discussion of Related Art

A semiconductor device includes an integrated circuit made up of metal-oxide-semiconductor field-effect transistors (MOS-FETs). In response to the growing demand for semiconductor devices with smaller pattern sizes and a tighter design rules, these MOS-FETs are being scaled down. However, this reduction in size of the MOS-FETs might compromise the operational characteristics of the semiconductor device. As a result, research is underway to address the technical challenges posed by this miniaturization and to deliver high performance semiconductor devices.

### SUMMARY

An embodiment of the inventive concept provides a semiconductor device with improved electrical characteristics and increased integration density.

According to an embodiment of the inventive concept, there is provided a semiconductor device including: first and second transistors on a substrate; an isolation transistor provided between the first and second transistors; a lower power line in a lower portion of the substrate; and a back-side gate contact penetrating the substrate and connected to the lower power line and a dummy gate electrode of the isolation transistor.

According to an embodiment of the inventive concept, there is provided a semiconductor device including: a substrate including first and second active regions, which are spaced apart from each other in a first direction; a first lower power line disposed in a lower portion of the substrate and overlapped with the first active region; a second lower power line disposed in a lower portion of the substrate and overlapped with the second active region; first and second inverters provided on the substrate and connected to each other in series; and an isolation circuit provided between the first inverter and the second inverter, wherein the isolation circuit includes: first source/drain patterns on the first active region; a first dummy gate electrode provided between the first source/drain patterns and crossing the first active region; second source/drain patterns on the second active region; a second dummy gate electrode provided between the second source/drain patterns, crossing the second active region and spaced apart from the first dummy gate electrode in the first direction; a first back-side gate contact penetrating the substrate and directly connected to the first lower power line and the first dummy gate electrode; and a second back-side gate contact penetrating the substrate and directly connected to the second lower power line and the second dummy gate electrode.

According to an embodiment of the inventive concept, there is provided a semiconductor device including: a substrate including first and second active regions, which are spaced apart from each other in a first direction; a first lower power line disposed in a lower portion of the substrate and overlapped with the first active region; a second lower power line disposed in a lower portion of the substrate and overlapped with the second active region; first source/drain patterns on the first active region; second source/drain patterns on the second active region; a first gate electrode provided between a first pair of the first source/drain patterns and between a first pair of the second source/drain patterns and crossing the first and second active regions; a second gate electrode provided between a second pair of the first source/drain patterns and between a second pair of the second source/drain patterns and crossing the first and second active regions; a first dummy gate electrode on the first active region and a second dummy gate electrode on the second active region, the first and second dummy gate electrodes located between the first gate electrode and the second gate electrode; a third dummy gate electrode on the first active region and a fourth dummy gate electrode on the second active region, the second gate electrode located between the first and third dummy gate electrodes and between the second and fourth dummy gate electrodes; first back-side gate contacts penetrating the substrate and directly connected to the first lower power line and the first and third dummy gate electrodes, respectively; second back-side gate contacts penetrating the substrate and directly connected to the second lower power line and the second and fourth dummy gate electrodes, respectively; first back-side active contacts penetrating the substrate and directly connected to the first lower power line and the first source/drain patterns, respectively, at first sides of the first and third dummy gate electrodes; and second back-side active contacts penetrating the substrate and directly connected to the second lower power line and the second source/drain patterns, respectively, at first sides of the second and fourth dummy gate electrodes.

### BRIEF DESCRIPTION OF THE DRAWINGS

FIGS. 1, 2 and 3 conceptual diagrams illustrating logic cells of a semiconductor device according to an embodiment of the inventive concept.
FIG. 4 is a plan view illustrating a portion of a semiconductor device according to an embodiment of the inventive concept.
FIGS. 5A and 5B are sectional views taken along lines A-A' and B-B' of FIG. 4.
FIG. 6 is a plan view illustrating a portion of a semiconductor device according to an embodiment of the inventive concept.
FIG. 7 is a sectional view taken along a line A-A' of FIG. 6.
FIG. 8 is a plan view illustrating a portion of a semiconductor device according to an embodiment of the inventive concept.
FIGS. 9A, 9B, and 9C are sectional views taken along lines A-A' and B-B' of FIG. 8.
FIG. 10 is a block diagram illustrating a semiconductor device according to an embodiment of the inventive concept.
FIG. 11 is a circuit diagram illustrating a portion of a semiconductor device according to an embodiment of the inventive concept.
FIG. 12 is a plan view illustrating a portion of a semiconductor device according to an embodiment of the inventive concept.
FIGS. 13A and 13B are sectional views taken along lines A-A' and B-B' of FIG. 12.
FIG. 14 is a circuit diagram illustrating a portion of a semiconductor device according to an embodiment of the inventive concept.
FIG. 15 is a plan view illustrating a portion of a semiconductor device according to an embodiment of the inventive concept.
FIG. 16 is a sectional view taken along a line A-A' of FIG. 15.
FIG. 17 is a circuit diagram illustrating a portion of a semiconductor device according to an embodiment of the inventive concept.
FIG. 18 is a plan view illustrating a portion of a semiconductor device according to an embodiment of the inventive concept.
FIG. 19 is a sectional view taken along a line A-A' of FIG. 18.
FIG. 20 is a circuit diagram illustrating a portion of a semiconductor device according to an embodiment of the inventive concept.
FIG. 21 is a plan view illustrating a portion of a semiconductor device according to an embodiment of the inventive concept.
FIG. 22 is a sectional view taken along a line A-A' of FIG. 21.
FIG. 23 is a circuit diagram illustrating a portion of a semiconductor device according to an embodiment of the inventive concept.
FIG. 24 is a plan view illustrating a portion of a semiconductor device according to an embodiment of the inventive concept.
FIG. 25 is a sectional view taken along a line A-A' of FIG. 24.
FIG. 26 is a circuit diagram illustrating a portion of a semiconductor device according to an embodiment of the inventive concept.
FIG. 27 is a plan view illustrating a portion of a semiconductor device according to an embodiment of the inventive concept.
FIGS. 28, 29, and 30 are sectional views taken along lines A-A', B-B', and C-C' of FIG. 27.
FIGS. 31, 33, 35, 37, and 39 are plan views illustrating an isolation circuit of a semiconductor device according to an embodiment of the inventive concept.
FIGS. 32, 34, 36, 38, and 40 are sectional views taken along lines I-I' of FIGS. 31, 33, 35, 37, and 39, respectively.

### DETAILED DESCRIPTION OF THE EMBODIMENTS

Example embodiments of the inventive concept will now be described more fully with reference to the accompanying drawings.

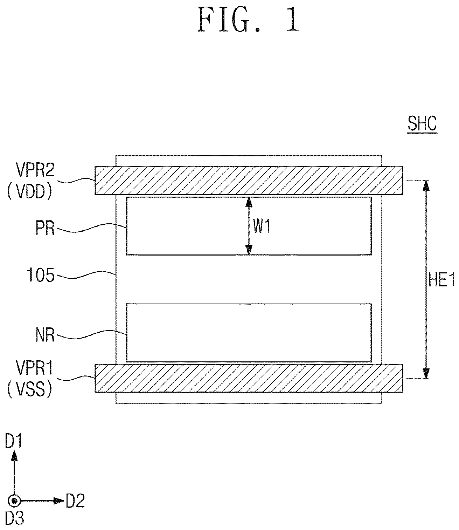

FIGS. 1 to 3 are diagrams illustrating logic cells of a semiconductor device according to an embodiment of the inventive concept.

Referring to FIG. 1, a single height cell SHC may be provided. For example, a first lower power line VPR1 and a second lower power line VPR2 may be provided in a lower portion of a substrate 105. The first lower power line VPR1 and the second lower power line VPR2 may be separated from each other along a first distance D1. The first lower power line VPR1 may be a conduction path, to which a source voltage VSS (e.g., a ground voltage) is provided. The second lower power line VPR2 may be a conduction path, to which a drain voltage VDD (e.g., a power voltage) is provided.

The single height cell SHC may be formed between the first lower power line VPR1 and the second lower power line VPR2. The single height cell SHC may include one P-channel metal-oxide-semiconductor field-effect transistor (PMOSFET) region PR and one N-channel metal-oxide-semiconductor field-effect transistor (NMOSFET) region NR. In other words, the single height cell SHC may have a complementary metal-oxide semiconductor (CMOS) structure provided between the first lower power line VPR1 and the second lower power line VPR2.

Each of the PMOSFET and NMOSFET regions PR and NR may have a first width in the first direction D1. A length of the single height cell SHC in the first direction D1 may be a first height HE1. The first height HE1 may be substantially equal to a distance (e.g., pitch) between the first lower power line VPR1 and the second lower power line VPR2.

The single height cell SHC may constitute a single logic cell. In the present specification, the logic cell may be a logic device (e.g., AND, OR, XOR, XNOR, inverter, and so forth), which is configured to execute a specific function. In other words, the logic cell may include transistors and interconnection lines, which are connected to each other to constitute the logic device.

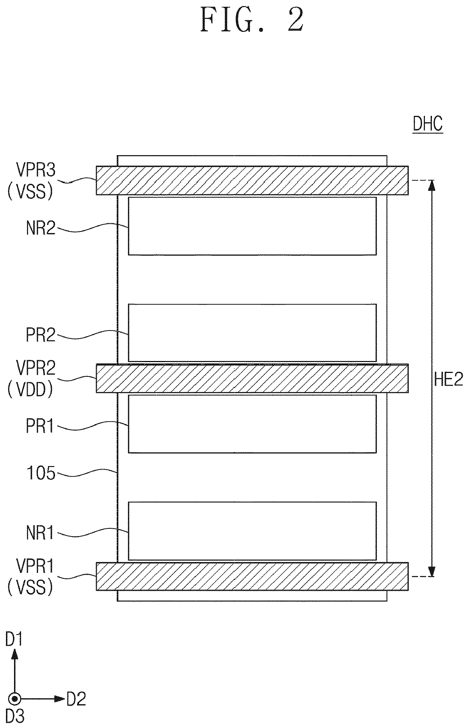

Referring to FIG. 2, a double height cell DHC may be provided. For example, a first lower power line VPR1, a second lower power line VPR2, and a third lower power line VPR3 may be provided on the substrate 105. The second lower power line VPR2 may be disposed between the first lower power line VPR1 and the third lower power line VPR3 along the first direction D1. The third lower power line VPR3 may be a conduction path, to which the source voltage VSS is provided.

The double height cell DHC may be formed between the first lower power line VPR1 and the third lower power line VPR3. The double height cell DHC may include a first PMOSFET region PR1, a second PMOSFET region PR2, a first NMOSFET region NR1, and a second NMOSFET region NR2.

The first NMOSFET region NR1 may be adjacent to the first lower power line VPR1. The second NMOSFET region NR2 may be adjacent to the third lower power line VPR3. The first and second PMOSFET regions PR1 and PR2 may be adjacent to the second lower power line VPR2. When viewed in a plan view, the second lower power line VPR2 may be disposed between the first and second PMOSFET regions PR1 and PR2. When viewed in a plan view, the first NMOSFET region NR1, the first PMOSFET region PR1, the second PMOSFET region PR2, and the second NMOSFET region NR2 may be arranged in sequence.

A length of the double height cell DHC in the first direction D1 may be a second height HE2. The second height HE2 may be about two times the first height HE1 of FIG. 1. The first and second PMOSFET regions PR1 and PR2 of the double height cell DHC may be combined to serve as a single PMOSFET region. Thus, a channel size of a PMOS transistor of the double height cell DHC may be greater than a channel size of a PMOS transistor of the single height cell SHC described with reference to FIG. 1.

For example, the channel size of the PMOS transistor of the double height cell DHC may be about two times the channel size of the PMOS transistor of the single height cell SHC. In this case, the double height cell DHC may be operated at a higher speed than the single height cell SHC. In an embodiment, the double height cell DHC shown in FIG. 2 may be referred to as a multi-height cell. In an embodiment, the multi-height cell may include a triple height cell whose cell height is about three times that of the single height cell SHC.

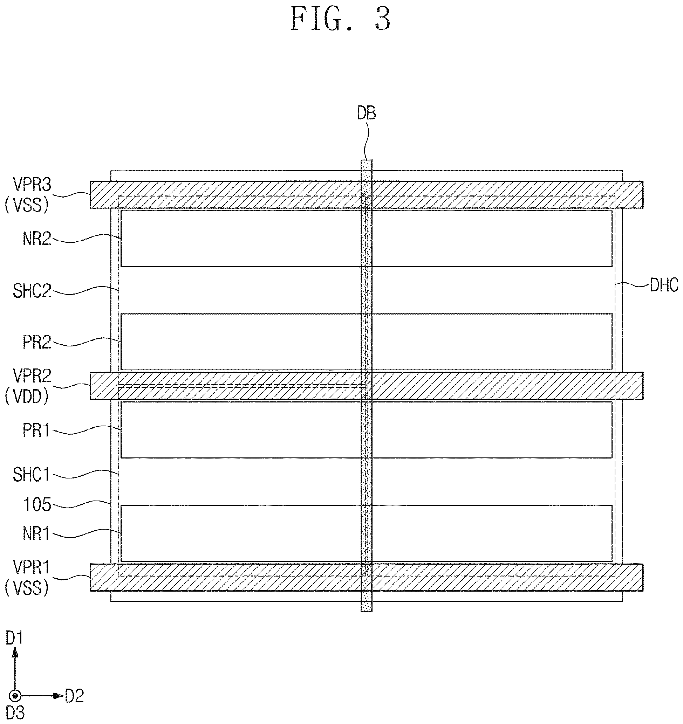

Referring to FIG. 3, a first single height cell SHC1, a second single height cell SHC2, and a double height cell DHC may be two-dimensionally disposed on the substrate 105. The first single height cell SHC1 may be disposed between the first and second lower power lines VPR1 and VPR2. The second single height cell SHC2 may be disposed between the second and third lower power lines VPR2 and VPR3. The second single height cell SHC2 may be adjacent to the first single height cell SHC1 in the first direction D1.

The double height cell DHC may be disposed between the first and third lower power lines VPR1 and VPR3. The double height cell DHC may be adjacent to the first and second single height cells SHC1 and SHC2 in a second direction D2. For example, a first portion of the double height cell DHC may be adjacent to the first single height cell SHC1 and a second portion of the double height cell DHC may be adjacent to the second single height cell SHC2.

A division structure DB may be provided between the first single height cell SHC1 and the double height cell DHC and between the second single height cell SHC2 and the double height cell DHC. For example, the division structure DB may be located between the first portion of the double height cell DHC and the first single height cell SHC1 and between the second portion of the double height cell DHC and the second single height cell SHC2. An active region of the double height cell DHC may be electrically separated from an active region of each of the first and second single height cells SHC1 and SHC2 by the division structure DB.

According to an embodiment of the inventive concept, the division structure DB, which is provided between standard cells, may include isolation transistors electrically isolating the standard cells from each other. This will be described in more detail hereinafter with reference to the accompanying drawings.

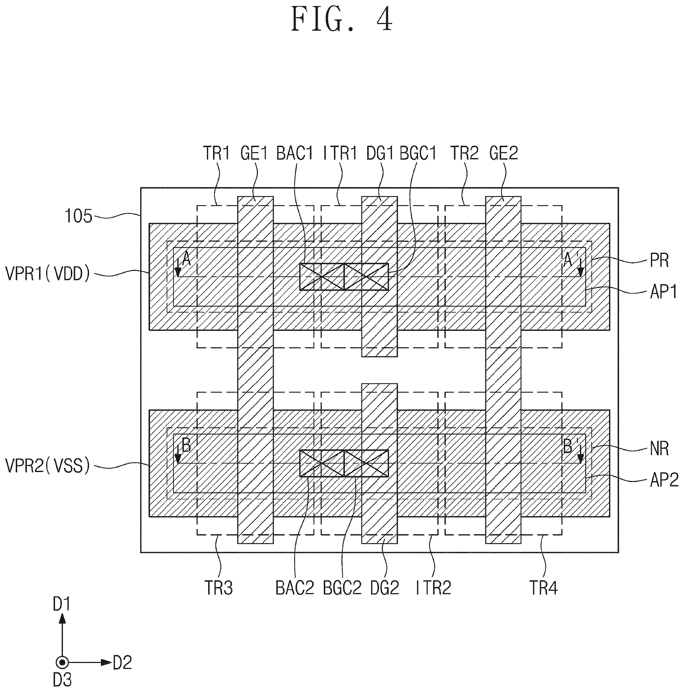

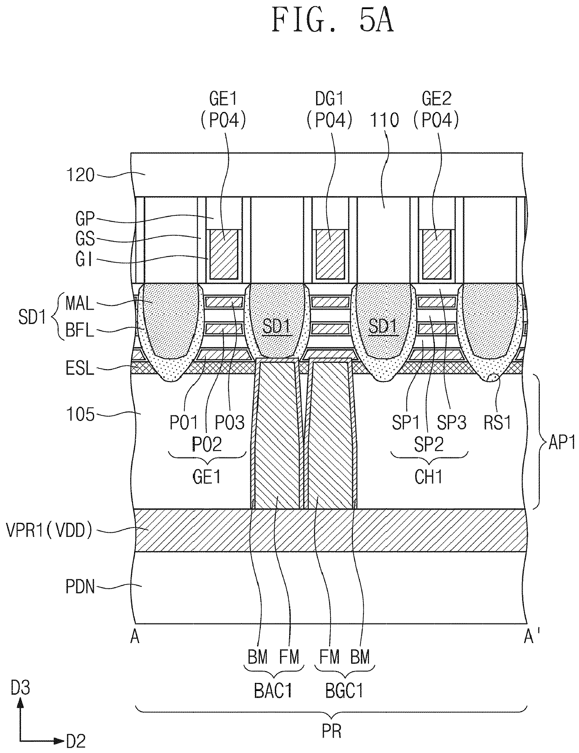

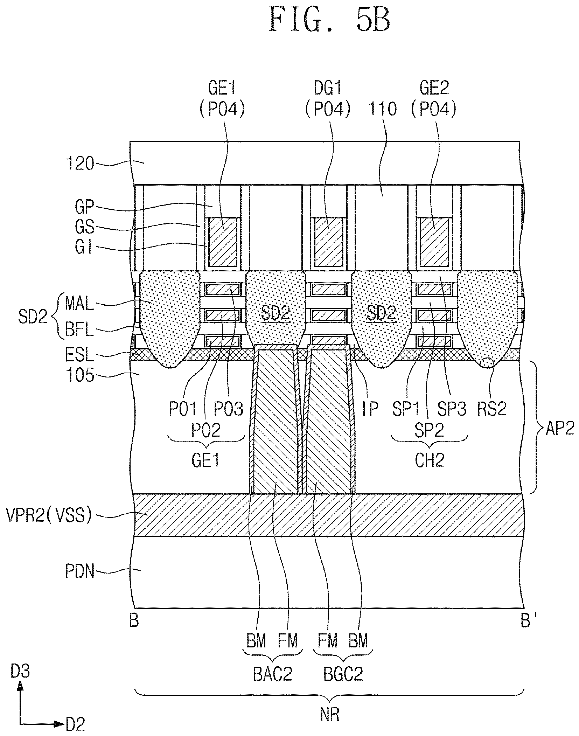

FIG. 4 is a plan view illustrating a semiconductor device according to an embodiment of the inventive concept. FIGS. 5A and 5B are sectional views taken along lines A-A' and B-B' of FIG. 4.

Referring to FIGS. 4, 5A, and 5B, the substrate 105 may include a silicon-based insulating layer. For example, the substrate 105 may be an insulating substrate. In an embodiment, the substrate 105 may include a silicon oxide layer, a silicon nitride layer, or a silicon oxynitride layer. Lower power lines VPR1 and VPR2 to be described below may be provided in the insulating layer of the substrate 105.

The substrate 105 may include a PMOSFET region PR and an NMOSFET region NR. Each of the PMOSFET and NMOSFET regions PR and NR may be extended in the second direction D2.

A first transistor TR1 and a second transistor TR2 may be provided on the PMOSFET region PR, and a first isolation transistor ITR1 may be provided between the first and second transistors TR1 and TR2 on the PMOSFET region PR. For example, the first and second transistors TR1 and TR2 and the first isolation transistor ITR1 may be PMOS field effect transistors (PMOS FETs).

The first transistor TR1 may include a first gate electrode GE1 extending in the first direction D1, source/drain regions provided in opposite portions of the PMOSFET region PR at both sides of the first gate electrode GE1, and a channel region below the first gate electrode GE1.

The second transistor TR2 may include a second gate electrode GE2 extending in the first direction D1, source/drain regions provided in opposite portions of the PMOSFET region PR at both sides of the second gate electrode GE2, and a channel region below the second gate electrode GE2.

The first isolation transistor ITR1 may include a first dummy gate electrode DG1 extending in the first direction D1, source/drain regions provided in opposite portions of the PMOSFET region PR at both sides of the first dummy gate electrode DG1, and a channel region below the first dummy gate electrode DG1.

The first transistor TR1 and the first isolation transistor ITR1 may be configured to share one source/drain region, and the first isolation transistor ITR1 and the second transistor TR2 may be configured to share another source/drain region.

A third transistor TR3 and a fourth transistor TR4 may be provided on the NMOSFET region NR, and a second isolation transistor ITR2 may be provided between the third and fourth transistors TR3 and TR4 on the NMOSFET region NR. For example, the third and fourth transistors TR3 and TR4 and the second isolation transistor ITR2 may be NMOS FETs.

The third transistor TR3 may include the first gate electrode GE1 extending in the first direction D1, source/drain regions provided in opposite portions of the NMOSFET region NR at both sides of the first gate electrode GE1, and a channel region below the first gate electrode GE1.

The fourth transistor TR4 may include the second gate electrode GE2 extending in the first direction D1, source/drain regions provided in opposite portions of the NMOSFET region NR at both sides of the second gate electrode GE2, and a channel region below the second gate electrode GE2.

The second isolation transistor ITR2 may include a second dummy gate electrode DG2 extending in the first direction D1, source/drain regions provided in opposite portions of the NMOSFET region NR at both sides of the second dummy gate electrode DG2, and a channel region below the second dummy gate electrode DG2.

The third transistor TR3 and the second isolation transistor ITR2 may be configured to share one source/drain region, and the second isolation transistor ITR2 and the fourth transistor TR4 may be configured to share another source/drain region.

In more detail, a first insulating pattern AP1 and a second insulating pattern AP2 may be defined by a trench, which is formed in an upper portion of the substrate 105. The first insulating pattern AP1 may be provided on the PMOSFET region PR. The second insulating pattern AP2 may be provided on the NMOSFET region NR. The first and second insulating patterns AP1 and AP2 may be extended in the second direction D2. Each of the first and second insulating patterns AP1 and AP2 may be a vertically-protruding portion of the substrate 105.

A device isolation layer may be disposed between the first and second insulating patterns AP1 and AP2. The device isolation layer may cover a side surface of each of the first and second insulating patterns AP1 and AP2. The device isolation layer may include a silicon oxide layer. The device isolation layer may not cover first and second channel patterns CH1 and CH2, which will be described below.

An etch stop layer ESL may be provided on each of the first and second insulating patterns AP1 and AP2. For example, the etch stop layer ESL may contact a surface of each of the first and second insulating patterns AP1 and AP2. The etch stop layer ESL may be formed of or include a material having an etch selectivity with respect to silicon (Si). For example, the etch stop layer ESL may include a silicon layer that is doped with at least one of oxygen (O) or carbon (C). In an embodiment, the etch stop layer ESL may be omitted.

The first channel pattern CH1 may be provided on the first insulating pattern AP1. The second channel pattern CH2 may be provided on the second insulating pattern AP2. Each of the first and second channel patterns CH1 and CH2 may include a first semiconductor pattern SP1, a second semiconductor pattern SP2, and a third semiconductor pattern SP3, which are sequentially stacked. The first to third semiconductor patterns SP1, SP2, and SP3 may be spaced apart from each other in a vertical direction (e.., a third direction D3).

Each of the first to third semiconductor patterns SP1, SP2, and SP3 may be formed of or include silicon (Si), germanium (Ge), or silicon germanium (SiGe). For example, each of the first to third semiconductor patterns SP1, SP2, and SP3 may be formed of or include crystalline silicon. In an embodiment, each of the first to third semiconductor patterns SP1, SP2, and SP3 may be a nanosheet.

A plurality of first source/drain patterns SD1 may be provided on the first insulating pattern AP1. A plurality of first recesses RS1 may be formed on the first insulating pattern AP1. The first recesses RS1 may protrude into the first insulating pattern AP1. The first source/drain patterns SD1 may be provided in the first recesses RS1, respectively. The first source/drain patterns SD1 may be impurity regions of a first conductivity type (e.g., p-type). The first channel pattern CH1 may be interposed between each pair of the first source/drain patterns SD1. In other words, each pair of the first source/drain patterns SD1 may be connected to each other by the stacked first to third semiconductor patterns SP1, SP2, and SP3.

A plurality of second source/drain patterns SD2 may be provided on the second insulating pattern AP2. A plurality of second recesses RS2 may be formed on the second active pattern AP2. The second recesses RS2 may protrude into the second insulating pattern AP2. The second source/drain patterns SD2 may be provided in the second recesses RS2, respectively. The second source/drain patterns SD2 may be impurity regions of a second conductivity type (e.g., n-type). The second channel pattern CH2 may be interposed between each pair of the second source/drain patterns SD2. In other words, each pair of the second source/drain patterns SD2 may be connected to each other by the stacked first to third semiconductor patterns SP1, SP2, and SP3.

The first and second source/drain patterns SD1 and SD2 may be epitaxial patterns, which are formed by a selective epitaxial growth (SEG) process. As an example, each of the first and second source/drain patterns SD1 and SD2 may have a top surface that is located at substantially the same level as a top surface of the third semiconductor pattern SP3. However, in an embodiment, the top surface of each of the first and second source/drain patterns SD1 and SD2 may be higher than the top surface of the third semiconductor pattern SP3.

The first source/drain patterns SD1 may include a semiconductor material (e.g., SiGe), whose lattice constant is greater than that of the first channel pattern CH1. Accordingly, each pair of the first source/drain patterns SD1 may exert a compressive stress on the first channel pattern CH1 therebetween. In an embodiment, the second source/drain patterns SD2 may be formed of or include the same semiconductor material (e.g., Si) as the second channel pattern CH2.

Each of the first source/drain patterns SD1 may include a buffer layer BFL and a main layer MAL on the buffer layer BFL. Referring back to FIG. 5A, the buffer layer BFL may cover an inner surface the first recess RS1. The main layer MAL may fill an unfilled region of the first recess RS1 covered with the buffer layer BFL. The main layer MAL may have a volume that is greater than that of the buffer layer BFL. Each of the buffer and main layers BFL and MAL may be formed of or include silicon germanium (SiGe). For example, the buffer layer BFL may contain a relatively low concentration of germanium (Ge). The main layer MAL may contain a relatively high concentration of germanium.

Each of the buffer and main layers BFL and MAL may contain an impurity (e.g., boron, gallium, or indium) that allows the first source/drain pattern SD1 to have a p-type conductivity. An impurity concentration of the main layer MAL may be higher than an impurity concentration of the buffer layer BFL. The buffer layer BFL may be used to protect the main layer MAL in a process of replacing certain semiconductor layers with first, second, and third inner electrodes PO1, PO2, and PO3 of a gate electrode GE.

Each of the second source/drain patterns SD2 may be formed of or include silicon (Si). The second source/drain pattern SD2 may further contain impurities (e.g., phosphorus, arsenic, or antimony) that allow the second source/drain pattern SD2 to have an n-type conductivity.

The first and second gate electrodes GE1 and GE2 may be provided to cross the first and second channel patterns CH1 and CH2 and to extend in the first direction D1. The first and second gate electrodes GE1 and GE2 may be spaced apart from each other in the second direction D2 with the first and second dummy gate electrodes DG1 and DG2 interposed therebetween. Each of the first and second gate electrodes GE1 and GE2 may be vertically overlapped with the first and second channel patterns CH1 and CH2.

Each of the first and second gate electrodes GE1 and GE2 may include a first inner electrode PO1 interposed between the etch stop layer ESL and the first semiconductor pattern SP1, a second inner electrode PO2 interposed between the first semiconductor pattern SP1 and the second semiconductor pattern SP2, a third inner electrode PO3 interposed between the second semiconductor pattern SP2 and the third semiconductor pattern SP3, and an outer electrode PO4 on the third semiconductor pattern SP3. The etch stop layer ESL may be interposed between the first inner electrode PO1 and the substrate 105. A gate insulating layer GI may be interposed between the first inner electrode PO1 and the etch stop layer ESL. The gate insulating layer GI may directly cover the etch stop layer ESL.

Each of the first and second gate electrodes GE1 and GE2 may be provided on a top surface, a bottom surface, and opposite side surfaces of each of the first to third semiconductor patterns SP1, SP2, and SP3. In other words, each of the transistors in the present embodiment may be a three-dimensional field effect transistor (e.g., MBCFET or GAAFET), in which the gate electrode is surrounds the channel region three-dimensionally.

A pair of gate spacers GS may be respectively disposed on opposite side surfaces of the outer electrode PO4 of each of the first and second gate electrodes GE1 and GE2. The gate spacers GS may be extended along the first and second gate electrodes GE1 and GE2 and in the first direction D1. Top surfaces of the gate spacers GS may be higher than top surfaces of the first and second gate electrodes GE1 and GE2. The top surfaces of the gate spacers GS may be coplanar with a top surface of a first interlayer insulating layer 110. The gate spacers GS may be formed of or include at least one of SiCN, SiCON, or SiN. In an embodiment, the gate spacers GS may be a multi-layered structure, which includes at least two different materials selected from SiCN, SiCON, and SiN.

A gate capping pattern GP may be provided on the first and second gate electrodes GE1 and GE2. The gate capping pattern GP may be extended along the first and second gate electrodes GE1 and GE2 and in the first direction D1. The gate capping pattern GP may be formed of or include a material having an etch selectivity with respect to the first interlayer insulating layer 110 and a second interlayer insulating layer 120, which will be described below. In detail, the gate capping pattern GP may be formed of or include at least one of SiON, SiCN, SiCON, or SiN.

The gate insulating layer GI may be interposed between the first and second gate electrodes GE1 and GE2 and the first channel pattern CH1 and between the first and second gate electrodes GE1 and GE2 and the second channel pattern CH2. The gate insulating layer GI may cover the top, bottom, and side surfaces of each of the first to third semiconductor patterns SP1, SP2, and SP3. The gate insulating layer GI may be interposed between the first inner electrode PO1 and the etch stop layer ESL.

The gate insulating layer GI may include a silicon oxide layer, a silicon oxynitride layer, and/or a high-k dielectric layer. The high-k dielectric layer may be formed of or include at least one of high-k dielectric materials whose dielectric constants are higher than that of silicon oxide. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The first and second gate electrodes GE1 and GE2 may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work-function metal, which can be used to adjust a threshold voltage of the transistor. By adjusting a thickness and composition of the first metal pattern, it is possible to realize a transistor having a desired threshold voltage. For example, the first to third inner electrodes PO1, PO2, and PO3 of the first and second gate electrodes GE1 and GE2 may be composed of the first metal pattern serving as the work-function metal.

The first metal pattern may include a metal nitride layer. For example, the first metal pattern may include a layer that is composed of at least one metallic material, which is selected from the group consisting of titanium (Ti), tantalum (Ta), aluminum (Al), tungsten (W) and molybdenum (Mo), and nitrogen (N). In an embodiment, the first metal pattern may further include carbon (C). The first metal pattern may include a plurality of work function metal layers, which are stacked.

The second metal pattern may be formed of or include a metallic material whose resistance is lower than the first metal pattern. For example, the second metal pattern may be formed of or include at least one metallic material, which is selected from the group consisting of tungsten (W), aluminum (Al), titanium (Ti), and tantalum (Ta). The outer electrode PO4 of the gate electrode GE may include the first metal pattern and the second metal pattern on the first metal pattern.

In an embodiment, the first dummy gate electrode DG1 may be disposed on the PMOSFET region PR between the first and second gate electrodes GE1 and GE2. The second dummy gate electrode DG2 may be disposed on the NMOSFET region NR between the first and second gate electrodes GE1 and GE2.

The first and second dummy gate electrodes DG1 and DG2 may be spaced apart from each other in the first direction D1. The first dummy gate electrode DG1 may be spaced apart from the first and second gate electrodes GE1 and GE2 by substantially the same distance. The second dummy gate electrode DG2 may be spaced apart from the first and second gate electrodes GE1 and GE2 by substantially the same distance.

The first dummy gate electrode DG1 may be vertically overlapped with the first channel pattern CH1 on the first insulating pattern AP1, and the second dummy gate electrode DG2 may be vertically overlapped with the second channel pattern CH2 on the second insulating pattern AP2. In other words, the first dummy gate electrode DG1 may overlap the first channel pattern CH1 on the first insulating pattern AP1 in the third direction D3, and the second dummy gate electrode DG2 may overlap the second channel pattern CH2 on the second insulating pattern AP2 in the third direction D3.

The first and second dummy gate electrodes DG1 and DG2 may have substantially the same structure as the first and second gate electrodes GE1 and GE2. In other words, each of the first and second dummy gate electrodes DG1 and DG2 may include the first inner electrode PO1 interposed between the etch stop layer ESL and the first semiconductor pattern SP1, the second inner electrode PO2 interposed between the first semiconductor pattern SP1 and the second semiconductor pattern SP2, the third inner electrode PO3 interposed between the second semiconductor pattern SP2 and the third semiconductor pattern SP3, and the outer electrode PO4 on the third semiconductor pattern SP3. In addition, the gate capping pattern GP may be provided on the first and second dummy gate electrodes DG1 and DG2. The gate insulating layer GI may be interposed between the first and second dummy gate electrodes DG1 and DG2 and the first channel pattern CH1 and between the first and second dummy gate electrodes DG1 and DG2 and the second channel pattern CH2.

Referring back to FIG. 5B, inner spacers IP may be provided on the NMOSFET region NR. In other words, the inner spacers IP may be provided on the second insulating pattern AP2. The inner spacers IP may be respectively interposed between the first to third inner electrodes PO1, PO2, and PO3 of the first and second gate electrodes GE1 and GE2 and the second source/drain pattern SD2. In addition, the inner spacers IP may be respectively interposed between the first to third inner electrodes PO1, PO2, and PO3 of the second dummy gate electrode DG2 and the second source/drain pattern SD2. The inner spacers IP may be in direct contact with the second source/drain pattern SD2. Each of the first to third inner electrodes PO1, PO2, and PO3 of the gate electrode GE may be spaced apart from the second source/drain pattern SD2 by the inner spacer IP.

The first interlayer insulating layer 110 may be provided on the substrate 105. The first interlayer insulating layer 110 may cover the gate spacers GS and the first and second source/drain patterns SD1 and SD2. A top surface of the first interlayer insulating layer 110 may be substantially coplanar with the top surface of the gate capping pattern GP and the top surface of the gate spacer GS. A second interlayer insulating layer 120 may be formed on the first interlayer insulating layer 110 to cover the gate capping pattern GP.

In an embodiment, the first and second lower power lines VPR1 and VPR2 may be provided in a lower portion of the substrate 105. The first and second lower power lines VPR1 and VPR2 may be extended in the second direction D2 to be parallel to each other. The first lower power line VPR1 may be vertically overlapped with the PMOSFET region PR. The second lower power line VPR2 may be vertically overlapped with the NMOSFET region NR.

The first and second lower power lines VPR1 and VPR2 may be formed of or include at least one selected from the group consisting of copper, molybdenum, tungsten, and ruthenium. A bottom surface of each of the first and second lower power lines VPR1 and VPR2 may be coplanar with a bottom surface of the substrate 105.

A power delivery network layer PDN may be provided on the bottom surface of the substrate 105. The power delivery network layer PDN may include a plurality of lower interconnection lines, which are electrically connected to the first and second lower power lines VPR1 and VPR2.

In an embodiment, the power delivery network layer PDN may include an interconnection network, which is configured to apply the power voltage VDD to the first lower power line VPR1. The power delivery network layer PDN may include an interconnection network, which is configured to apply the ground voltage VSS to the second lower power line VPR2.

In an embodiment, a first back-side active contact BAC1 may be provided to penetrate the substrate 105 and connect the first lower power line VPR1 to the first source/drain pattern SD1. A first back-side gate contact BGC1 may be provided to penetrate the substrate 105 and connect the first lower power line VPR1 to the first dummy gate electrode DG1. In other words, the power voltage VDD may be applied to the first dummy gate electrode DG1 and the first source/drain pattern SD1 of the first isolation transistor ITR1, and thus, the first isolation transistor ITR1 is turned off to electrically isolate or separate the first and second transistors TR1 and TR2 from each other.

A second back-side active contact BAC2 may be provided to penetrate the substrate 105 and connect the second lower power line VPR2 to the second source/drain pattern SD2. A second back-side gate contact BGC2 may be provided to penetrate the substrate 105 and connect the second lower power line VPR2 to the second dummy gate electrode DG2. In other words, the ground voltage VSS may be applied to the second dummy gate electrode DG2 and the second source/drain pattern SD2 of the second isolation transistor ITR2, and thus, the second isolation transistor ITR2 is turned off to electrically isolate or separate the third and fourth transistors TR3 and TR4 from each other.

Each of the first and second back-side gate contacts BGC1 and BGC2 may be provided to penetrate the etch stop layer ESL and may be in direct contact with the first inner electrode PO1, which is the lowermost inner electrode of the first dummy gate electrode DG1. Side surfaces of the first and second back-side gate contacts BGC1 and BGC2 may be in partial contact with the first and second back-side active contacts BAC1 and BAC2. For example, side surfaces of the first and second back-side gate contacts BGC1 and BGC2 adjacent to the first and second lower power lines VPR1 and VPR2 may be in partial contact with the first and second back-side active contacts BAC1 and BAC2.

In FIGS. 5A and 5B, the first and second back-side gate contacts BGC1 and BGC2 and the first and second back-side active contacts BAC1 and BAC2 are illustrated to have top surfaces that are located at substantially the same level, but the inventive concept is not limited to this example. For example, the top surfaces of the first and second back-side gate contacts BGC1 and BGC2 may be located at a level different from the top surfaces of the first and second back-side active contacts BAC1 and BAC2.

Each of the first and second back-side gate contacts BGC1 and BGC2 and the first and second back-side active contacts BAC1 and BAC2 may include a conductive pattern FM and a barrier pattern BM enclosing the conductive pattern FM. For example, the conductive pattern FM may be formed of or include at least one of metallic materials (e.g., aluminum, copper, tungsten, molybdenum, and cobalt). The barrier pattern BM may be provided to cover side and bottom surfaces of the conductive pattern FM. In an embodiment, the barrier pattern BM may include a metal layer and a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN).

Furthermore, a metal-semiconductor compound layer (e.g., a silicide layer) may be interposed between the first and second back-side active contacts BAC1 and BAC2 and the first and second source/drain patterns SD1 and SD2. For example, the metal-semiconductor compound layer may be formed of or include at least one of titanium silicide, tantalum silicide, tungsten silicide, nickel silicide, or cobalt silicide.

According to an embodiment of the inventive concept, since the first and second isolation transistors ITR1 and ITR2 are used to electrically isolate the first, second, third and fourth transistors TR1, TR2, TR3, and TR4 from each other, there is no need to have an additional structure for electric isolation, and thus, the layout of the semiconductor device may be simplified without any locally-changed region. Thus, the reliability of the semiconductor device may be improved and the fabrication process thereof may be performed in a unified and simplified manner. In addition, since the first and second back-side active contacts BAC1 and BAC2 and the first and second back-side gate contacts BGC1 and BGC2 are used to connect the first and second lower power lines VPR1 and VPR2, which are provided in the lower portion of the substrate 105, to the isolation transistors ITR1 and ITR2, it is possible to increase an integration density of the semiconductor device.

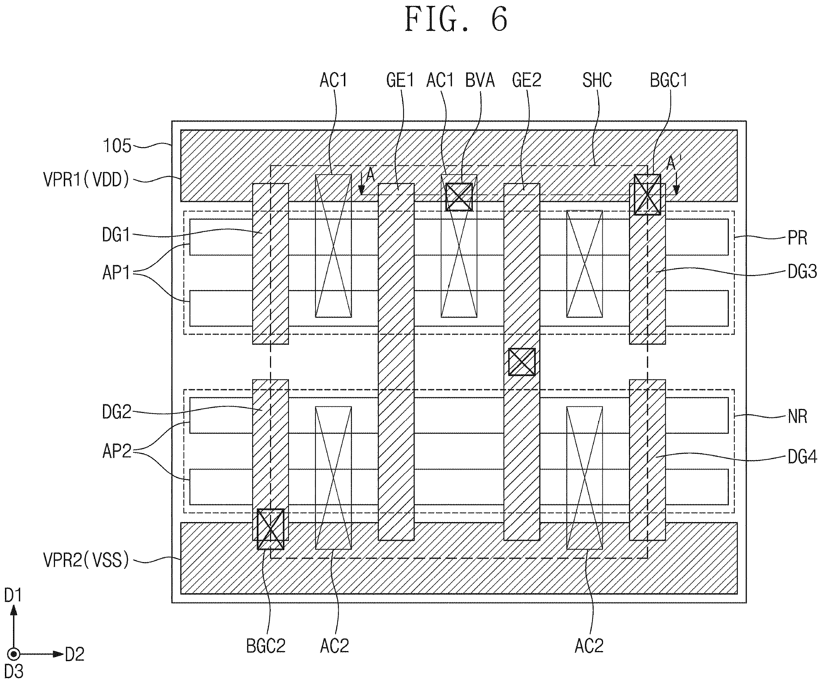

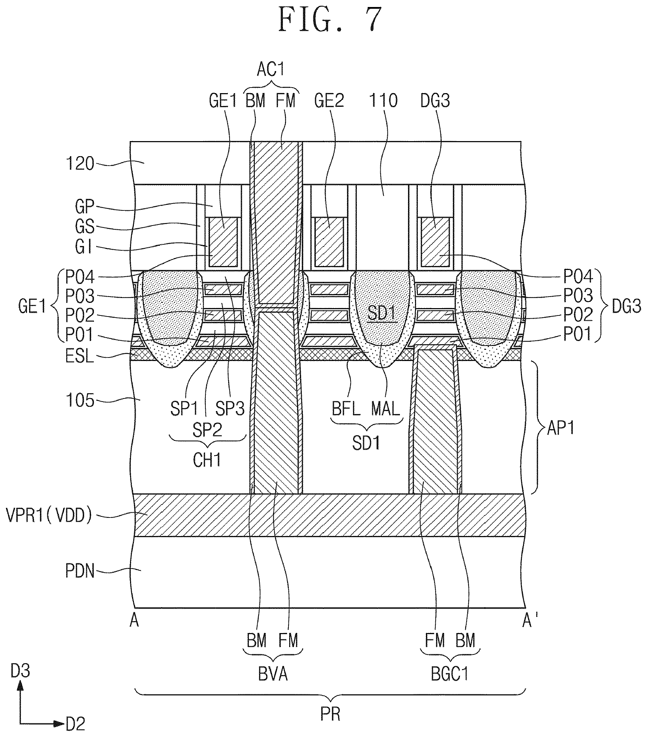

FIG. 6 is a plan view illustrating a portion of a semiconductor device according to an embodiment of the inventive concept. FIG. 7 is a sectional view taken along a line A-A' of FIG. 6. For brevity, a previously described element may be identified by the same reference number without repeating an overlapping description thereof.

Referring to FIGS. 6 and 7, as previously described with reference to FIG. 1, the single height cell SHC may be formed between the first lower power line VPR1 and the second lower power line VPR2. The single height cell SHC may include one PMOSFET region PR and one NMOSFET region NR. The PMOSFET and NMOSFET regions PR and NR may be provided between the first lower power line VPR1 and the second lower power line VPR2. The first and second lower power lines VPR1 and VPR2 may be provided in a lower portion of the substrate 105 and may be extended in the second direction D2 to be parallel to each other.

The single height cell SHC may include logic transistors constituting a logic circuit.

As described above, the first insulating patterns AP1 may be provided in the PMOSFET region PR, and the second insulating patterns AP2 may be provided in the NMOSFET region NR. The first and second insulating patterns AP1 and AP2 may be extended in the second direction D2. Each of the first and second insulating patterns AP1 and AP2 may be a vertically-protruding portion of the substrate 105.

The first channel pattern CH1 may be provided on the first insulating pattern AP1. The second channel pattern CH2 may be provided on the second insulating pattern AP2. Each of the first and second channel patterns CH1 and CH2 may include the first, second, third semiconductor patterns SP1, SP2, and SP3 sequentially stacked, as described above.

The first source/drain patterns SD1 may be provided on the first insulating pattern AP1. The first channel pattern CH1 may be interposed between a pair of the first source/drain patterns SD1.

The second source/drain patterns SD2 may be provided on the second insulating pattern AP2. The second source/drain patterns SD2 may be impurity regions of a second conductivity type (e.g., n-type). The second channel pattern CH2 may be interposed between a pair of the second source/drain patterns SD2.

The first and second gate electrodes GE1 and GE2 may be extended in the first direction D1 to cross the first and second channel patterns CH1 and CH2. Each of the first and second gate electrodes GE1 and GE2 may be vertically overlapped with the first and second channel patterns CH1 and CH2.

In an embodiment, first, second, third, and fourth dummy gate electrodes DG1, DG2, DG3, and DG4 may be disposed on a border of the single height cell SHC.

The first and third dummy gate electrodes DG1 and DG3 may be disposed on opposite borders of the single height cell SHC in the PMOSFET region PR, and the second and fourth dummy gate electrodes DG2 and DG4 may be disposed on opposite borders of the single height cell SHC in the NMOSFET region NR. The second dummy gate electrode DG2 may be spaced apart from the first dummy gate electrode DG1 in the first direction D1, and the fourth dummy gate electrode DG4 may be spaced apart from the third dummy gate electrode DG3 in the first direction D1.

The first and third dummy gate electrodes DG1 and DG3 may be vertically overlapped with the first channel patterns CH1, and the second and fourth dummy gate electrodes DG2 and DG4 may be vertically overlapped with the second channel patterns CH2. For example, the first and third dummy gate electrodes DG1 and DG3 may overlap the first channel patterns CH1 in the third direction D3, and the second and fourth dummy gate electrodes DG2 and DG4 may overlap the second channel patterns CH2 in the third direction D3.

The first and second gate electrodes GE1 and GE2 may be disposed between the first and third dummy gate electrodes DG1 and DG3 and between the second and fourth dummy gate electrodes DG2 and DG4 to be spaced apart from each other with a constant pitch.

The first, second, third, and fourth dummy gate electrodes DG1, DG2, DG3, and DG4, which are disposed on the border of the single height cell SHC, may be electrically connected to the first and second lower power lines VPR1 and VPR2 through the first and second back-side gate contacts BGC1 and BGC2. The PMOS transistors including the first and third dummy gate electrodes DG1 and DG3 may be turned off by applying the power voltage VDD to at least one of the first and third dummy gate electrodes DG1 and DG3 through the first back-side gate contact BGC1. The NMOS transistors including the second and fourth dummy gate electrodes DG2 and DG4 may be turned off by applying the ground voltage VSS to the second and fourth dummy gate electrodes DG2 and DG4 through the second back-side gate contact BGC2.

At least a portion of the first and second back-side gate contacts BGC1 and BGC2 may be overlapped with the first or second lower power lines VPR1 or VPR2. Each of the back-side gate contacts BGC1 and BGC2 may be provided to penetrate the substrate 105 and connect the first or second lower power lines VPR1 or VPR2 to at least one of the first, second, third, and fourth dummy gate electrodes DG1, DG2, DG3, and DG4.

Each of the first and second back-side gate contacts BGC1 and BGC2 may be provided to penetrate the etch stop layer ESL and may be in direct contact with the first inner electrode PO1 of at least one of the first, second, third, and fourth dummy gate electrodes DG1, DG2, DG3, and DG4.

First active contacts AC1 may be provided to penetrate the first and second interlayer insulating layers 110 and 120 and may be coupled to the first source/drain patterns SD1, and second active contacts AC2 may be provided to penetrate the first and second interlayer insulating layers 110 and 120 and may be coupled to the second source/drain patterns SD2.

A back-side via contact BVA may be provided to penetrate the substrate 105 and connect the first lower power line VPR1 to the first source/drain pattern SD1. The back-side via contact BVA may be provided to penetrate a portion of the first source/drain pattern SD1 and may be in direct contact with the first active contact AC1.

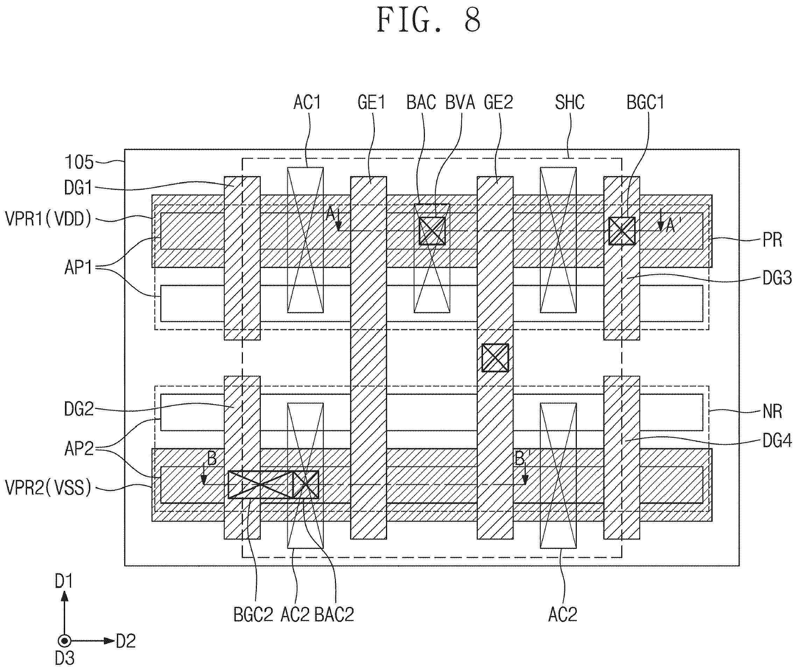

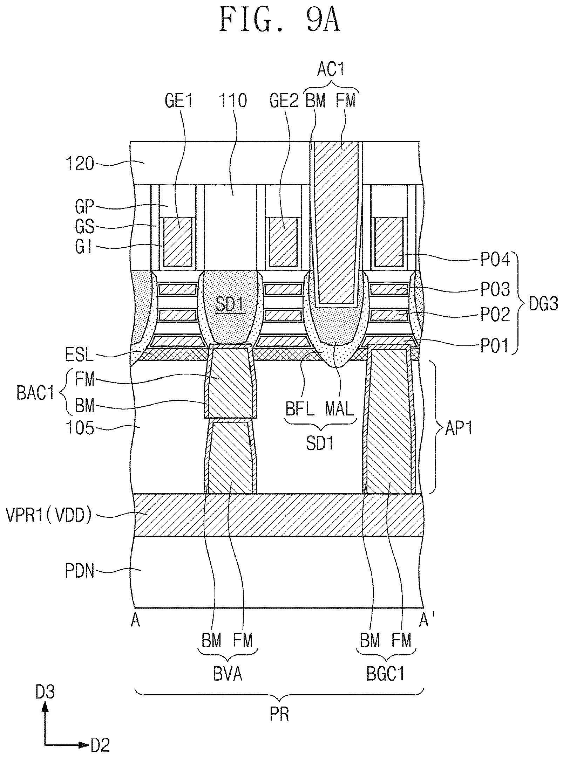

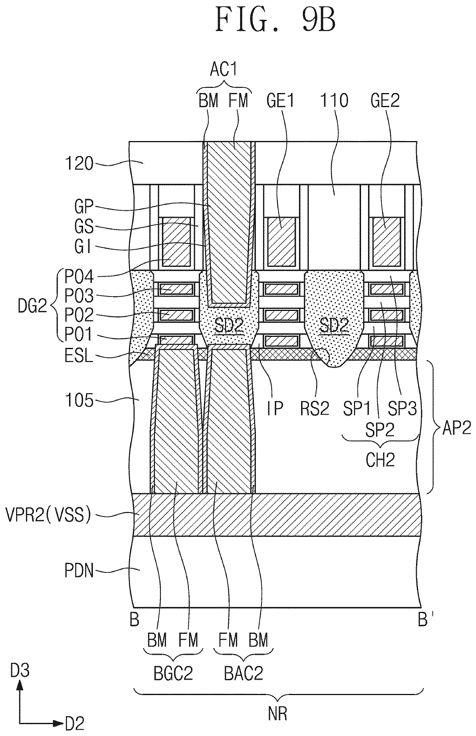

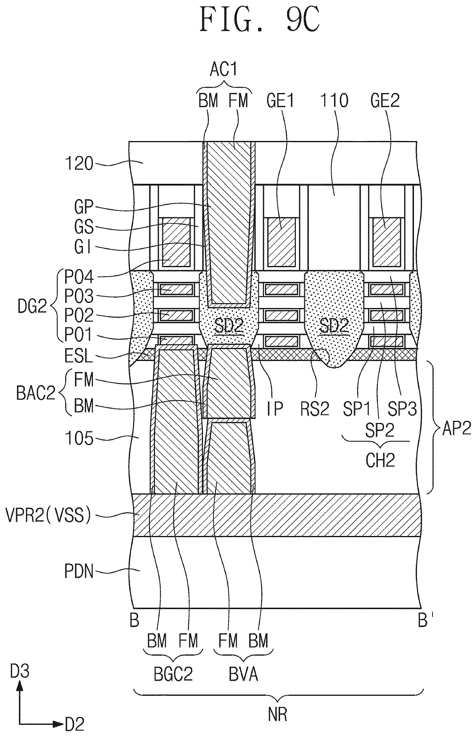

FIG. 8 is a plan view illustrating a portion of a semiconductor device according to an embodiment of the inventive concept. FIGS. 9A, 9B, and 9C are sectional views taken along lines A-A', B-B', and C-C' of FIG. 8. For brevity, a previously described element may be identified by the same reference number without repeating an overlapping description thereof.

Referring to FIGS. 8, 9A, 9B, and 9C, the first, second, third, and fourth dummy gate electrodes DG1, DG2, DG3, and DG4 may be disposed on the border of the single height cell SHC, as previously described with reference to FIG. 6.

As described above, the first insulating patterns AP1 may be provided in the PMOSFET region PR, and the second insulating patterns AP2 may be provided in the NMOSFET region NR.

In an embodiment, the first lower power line VPR1 may be overlapped with at least one of the first insulating patterns AP1. The second lower power line VPR2 may be overlapped with at least one of the second insulating patterns AP2.

In an embodiment, the first and second back-side gate contacts BGC1 and BGC2 may be provided to connect the first, second, third, and fourth dummy gate electrodes DG1, DG2, DG3, and DG4 to the first or second lower power lines VPR1 or VPR2.

Referring to FIG. 9A, the first source/drain pattern SD1 between the first and second gate electrodes GE1 and GE2 may be connected to the first lower power line VPR1 through the first back-side active contact BAC1 and the back-side via contact BVA. Here, the first back-side active contact BAC1 and the back-side via contact BVA may be stacked such that the back-side via contact BVA is located between the first back-side active contact BAC1 and the first lower power line VPR1.

Referring to FIG. 9B, the second back-side active contact BAC2 may connect the second lower power line VPR2 to the second source/drain pattern SD2.

Referring to FIG. 9C, the second source/drain pattern SD2, which is disposed beside the second dummy gate electrode DG2, may be connected to the second lower power line VPR2 through the second back-side active contact BAC2 and the back-side via contact BVA.

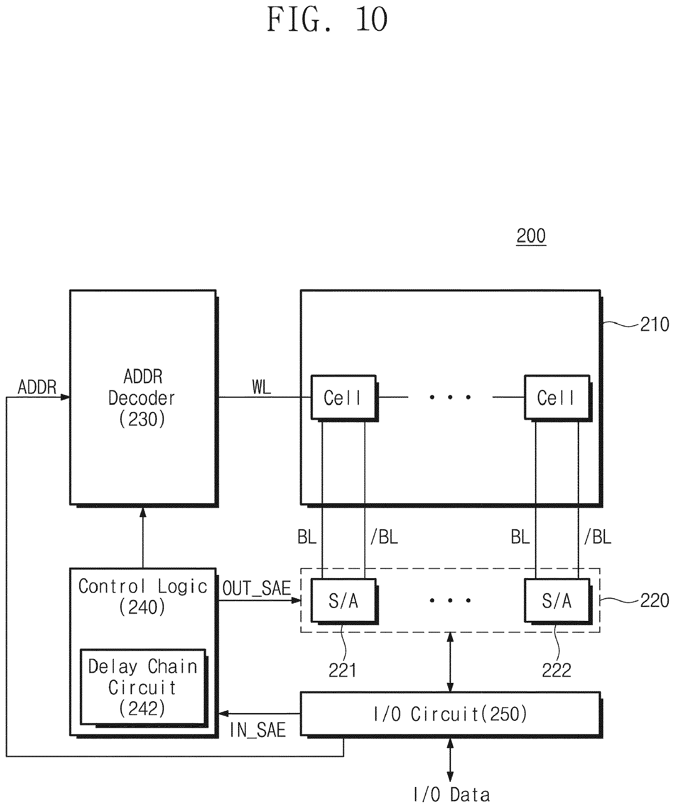

FIG. 10 is a block diagram illustrating a semiconductor device according to an embodiment of the inventive concept.

Referring to FIG. 10, a static random access memory (SRAM) 200 may include a SRAM cell array 210, a sense amplifier circuit 220, an address decoder 230, a control logic 240, and an input/output circuit 250.

The SRAM cell array 210 may include a plurality of SRAM bit cells, which are connected to a plurality of bit lines BL and a plurality of word lines WL. Each bit cell may be accessed through one of the word lines WL and one of the bit lines BL. Each of the bit cells may be connected to a pair of bit lines BL and /BL based on a word line voltage. Each of the bit cells may include a latch circuit and pass transistors that receive the word line voltage as a gate voltage. Voltages of the paired bit lines BL and /BL, which are pre-charged according to data stored in the latch circuit, may be varied during a sensing operation. The stored data may be sensed by sensing the varied voltage.

The sense amplifier circuit 220 may include a plurality of sense amplifiers 221 to 222.

A pair of bit lines BL and BL may be connected to individuals ones of the sense amplifiers 221 to 222. In the sensing operation, data may be sensed by measuring a variation in voltages of the paired bit lines BL and /BL using each sense amplifier connected thereto.

The address decoder 230 may be configured to decode address information ADDR, which are received from the outside, and select at least one of the word lines WL.

The control logic 240 may be configured to control the overall operation of the SRAM 200. As an example, the control logic 240 may be configured to transfer sense amplifier enable signals (SAE), which are received from the input/output circuit 250, to the sense amplifier circuit 220. For example, the control logic 240 may include a delay chain circuit 242, which is configured to delay a sense amplifier enable signal IN_SAE, which is received from the input/output circuit 250, and output the delayed signal (hereinafter, a sense amplifier enable signal OUT_SAE).

The input/output circuit 250 may be configured to exchange input/output data (e.g., read or write data) with the outside (e.g., controller). The input/output circuit 250 may be configured to transfer the address information, which is received from the outside, to the address decoder 230. Furthermore, the input/output circuit 250 may be configured to transfer the sense amplifier enable signal SAE, which is received from the outside, to the control logic 240.

Referring to FIG. 10, in the reading operation of the SRAM 200, the word line WL of the SRAM cell array 210 may be activated by the address decoder 230, and one of the paired bit lines BL and /BL may be discharged depending on data stored in the bit cell. Thereafter, if the sense amplifier circuit 220 is activated by the sense amplifier enable signal SAE, a voltage difference between the paired bit lines BL and /BL may be amplified by the sense amplifier circuit 220. In other words, there should be a sufficient time interval between the moment when the word line WL is activated and the moment when the sense amplifier circuit 220 is activated by the sense amplifier enable signal SAE.

During the reading operation on the SRAM 200, the more the bit cells connected to the paired bit lines BL and /BL, the longer the time interval between the moment when the word line WL is activated and the moment when the sense amplifier circuit 220 is activated by the sense amplifier enable signal SAE. Thus, the delay chain circuit 242 may be required to additionally delay the sense amplifier enable signal SAE. The delay chain circuit 242 may include a plurality of inverters, which are connected in series. The number of the inverters in the delay chain circuit 242 may vary depending on the number of the bit cells, which are connected to the paired bit lines BL and BL. The delay chain circuit 242 may be configured to delay input signals and output the delayed signals. Each of the inverters may be composed of PMOS and NMOS transistors.

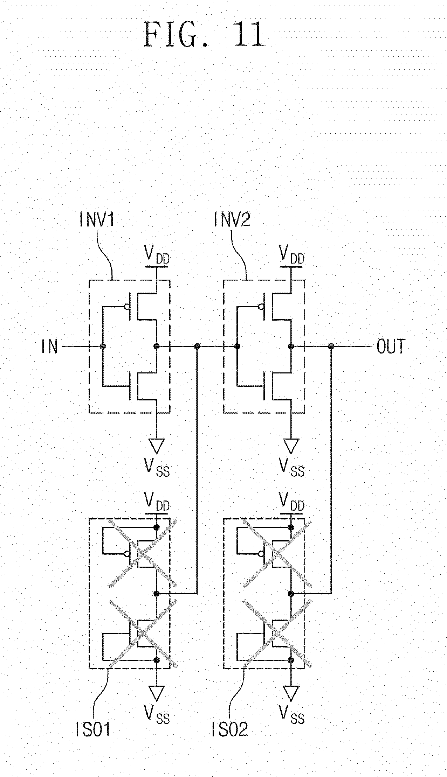

FIG. 11 is a circuit diagram illustrating a portion of a semiconductor device according to an embodiment of the inventive concept.

Referring to FIG. 11, a semiconductor device may include first and second inverters INV1 and INV2 and first and second isolation circuits ISO1 and ISO2. In the present embodiment, two inverters are illustrated to be connected in series, but the inventive concept is not limited to this example; for example, the semiconductor device may be provided to have even-numbered inverters greater than two. In addition, two isolation circuits are illustrated, but the inventive concept is not limited to this example; for example, the semiconductor device may be provided to have more than two isolation circuits.

Each of the first and second inverters INV1 and INV2 may be composed of a PMOS transistor and an NMOS transistor.

Each of the first and second isolation circuits ISO1 and ISO2 may be composed of a PMOS transistor and an NMOS transistor. An output terminal of the first isolation circuit ISO 1 may be connected to an output terminal of the first inverter INV1. An output terminal of the second isolation circuit ISO2 may be connected to an output terminal of the second inverter INV2. The power voltage VDD may be applied to one node of the PMOS transistor of each of the first and second isolation circuits ISO1 and ISO2, and the ground voltage VSS may be applied to one node of the NMOS transistor of each of the first and second isolation circuits ISO1 and ISO2. The power voltage VDD may be applied to a gate terminal of the PMOS transistor of each of the first and second isolation circuits ISO1 and ISO2, and the ground voltage VSS may be applied to a gate terminal of the NMOS transistor of each of the first and second isolation circuits ISO1 and ISO2. As a result, the PMOS and NMOS transistors constituting the first and second isolation circuits ISO1 and ISO2 may be turned off. In other words, the first and second isolation circuits ISO1 and ISO2 may electrically separate or isolate the first and second inverters INV1 and INV2 from other neighboring devices.

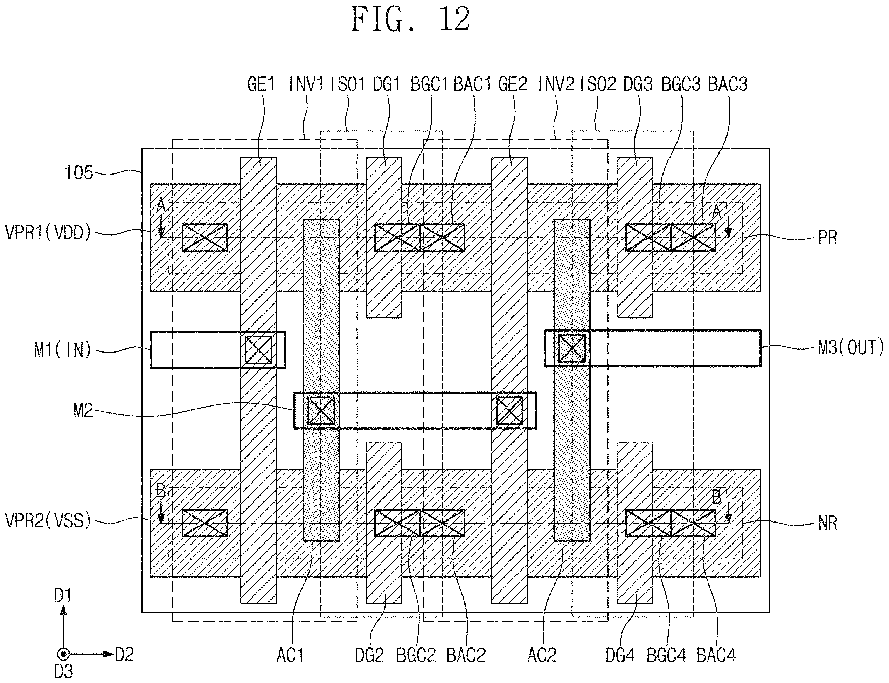

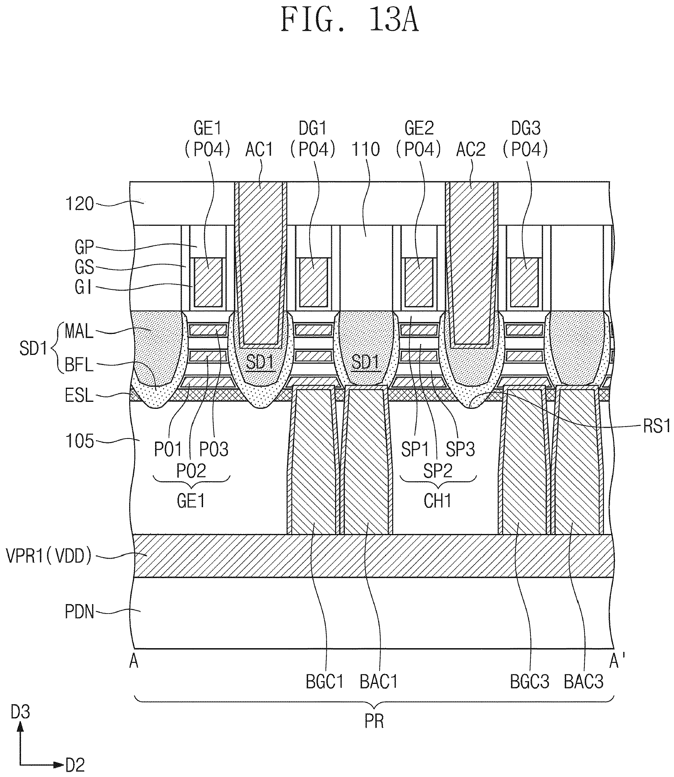

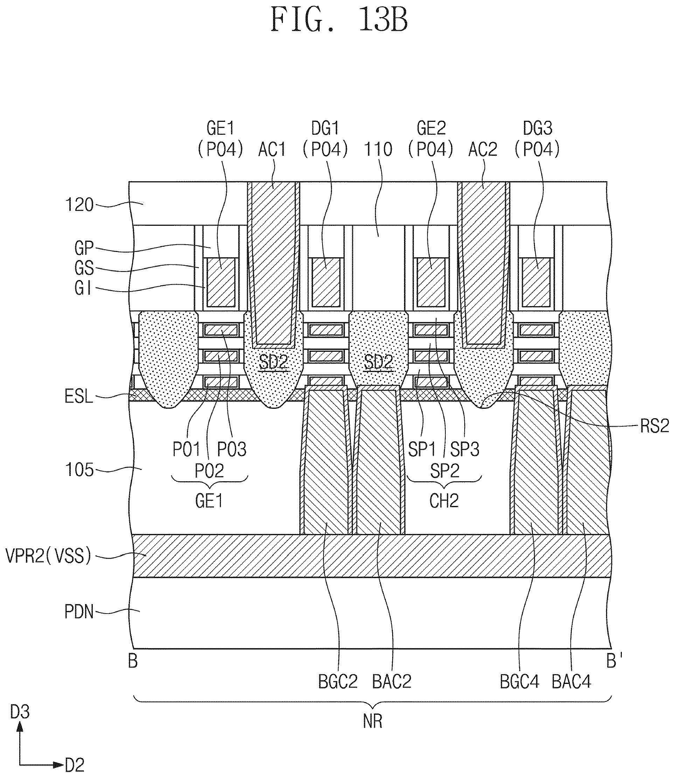

FIG. 12 is a plan view illustrating a portion of a semiconductor device according to an embodiment of the inventive concept (e.g., corresponding to a layout according to the circuit diagram of FIG. 11). FIGS. 13A and 13B are sectional views taken along lines A-A' and B-B' of FIG. 12. For brevity, an element described with reference to FIGS. 4, 5A, and 5B may be identified by the same reference number without repeating an overlapping description thereof.

Referring to FIGS. 11, 12, 13A, and 13B, the substrate 105 may include the PMOSFET region PR and the NMOSFET region NR. The substrate 105 may be an insulating substrate, as described above.

The first and second inverters INV1 and INV2 and the first and second isolation circuits ISO1 and ISO2 may be provided on the substrate 105. The first isolation circuit ISO1 may be disposed between the first and second inverters INV1 and INV2, and the second inverter INV2 may be disposed between the first and second isolation circuits ISO1 and ISO2.

In more detail, the first channel pattern CH1 may be provided on the PMOSFET region PR, and the second channel pattern CH2 may be provided on the NMOSFET region NR. Each of the first and second channel patterns CH1 and CH2 may include the first semiconductor pattern SP1, the second semiconductor pattern SP2, and the third semiconductor pattern SP3, which are sequentially stacked and are spaced apart from each other in the third direction D3.

The first and second gate electrodes GE1 and GE2 may be extended in the first direction D1 to cross the PMOSFET and NMOSFET regions PR and NR. The first and second gate electrodes GE1 and GE2 may be disposed to cross the first and second channel patterns CH1 and CH2.

Each of the first and second gate electrodes GE1 and GE2 may include the first inner electrode PO1 interposed between the etch stop layer ESL and the first semiconductor pattern SP1, the second inner electrode PO2 interposed between the first semiconductor pattern SP1 and the second semiconductor pattern SP2, the third inner electrode PO3 interposed between the second semiconductor pattern SP2 and the third semiconductor pattern SP3, and the outer electrode PO4 on the third semiconductor pattern SP3.

The first dummy gate electrode DG1 may be disposed on the PMOSFET region PR between the first and second gate electrodes GE1 and GE2. The second dummy gate electrode DG2 may be disposed on the NMOSFET region NR between the first and second gate electrodes GE1 and GE2. The second dummy gate electrode DG2 may be spaced apart from the first dummy gate electrode DG1 in the first direction D1.

The third dummy gate electrode DG3 may be disposed on a portion of the PMOSFET region PR, which is placed beside the second gate electrode GE2. The fourth dummy gate electrode DG4 may be disposed on a portion of the NMOSFET region NR, which is placed beside the second gate electrode GE2. The fourth dummy gate electrode DG4 may be spaced apart from the third dummy gate electrode DG3 in the first direction D1.

The first and third dummy gate electrodes DG1 and DG3 may be vertically overlapped with the first channel pattern CH1 on the first insulating pattern AP1, and the second and fourth dummy gate electrodes DG2 and DG4 may be vertically overlapped with the second channel pattern CH2 on the second insulating pattern AP2. The first and second dummy gate electrodes DG1 and DG2 may have substantially the same structure as the first and second gate electrodes GE1 and GE2.

The first source/drain patterns SD1 may be disposed on portions of the PMOSFET region PR, which are placed at both sides of the first and second gate electrodes GE1 and GE2 and the first and second dummy gate electrodes DG1 and DG2.

The first source/drain patterns SD1 may be impurity regions of a first conductivity type (e.g., p-type). The first channel pattern CH1 may be interposed between a pair of the first source/drain patterns SD1. In other words, each pair of the first source/drain patterns SD1 may be connected to each other by the stacked first to third semiconductor patterns SP1, SP2, and SP3.

The second source/drain patterns SD2 may be disposed on portions of the NMOSFET region NR, which are placed at both sides of the first and second gate electrodes GE1 and GE2 and the first and second dummy gate electrodes DG1 and DG2.

The second source/drain patterns SD2 may be impurity regions of a second conductivity type (e.g., n-type). The second channel pattern CH2 may be interposed between each pair of the second source/drain patterns SD2. In other words, each pair of the second source/drain patterns SD2 may be connected to each other by the stacked first to third semiconductor patterns SP1, SP2, and SP3.

The first and second lower power lines VPR1 and VPR2 may be provided in a lower portion of the substrate 105. The first and second lower power lines VPR1 and VPR2 may be extended in the second direction D2 to be parallel to each other. The first lower power line VPR1 may be vertically overlapped with the PMOSFET region PR. The second lower power line VPR2 may be vertically overlapped with the NMOSFET region NR. In an embodiment, the power voltage VDD may be applied to the first lower power line VPR1, and the ground voltage VSS may be applied to the second lower power line VPR2.

The first active contact AC1 may be electrically connected to the first source/drain patterns SD1 and SD2, which are provided between the first gate electrode GE1 and the first dummy gate electrode DG1/second dummy gate electrode DG2. In other words, an output terminal of the first inverter INV1 and an output terminal of the first isolation circuit ISO1 may be electrically connected to each other through the first active contact AC1.

The second active contact AC2 may be electrically connected to the first and second source/drain patterns SD1 and SD2, which are provided between the second gate electrode GE2 and the third dummy gate electrode DG3/fourth dummy gate electrode DG4. In other words, an output terminal of the second inverter INV2 and an output terminal of the second isolation circuit ISO2 may be electrically connected to each other through the second active contact AC2.

When viewed in a plan view, the first and second active contacts AC1 and AC2 may have a bar shape extending in the first direction D1.

In an embodiment, the first back-side active contact BAC1 may be provided to penetrate the substrate 105 and connect the first lower power line VPR1 to the first source/drain pattern SD1, which is provided between the first dummy gate electrode DG1 and the second gate electrode GE2. The first back-side gate contact BGC1 may be provided to penetrate the substrate 105 and connect the first lower power line VPR1 to the first dummy gate electrode DG1. Thus, the PMOS transistor constituting the first isolation circuit ISO1 may be turned off.

One node of the PMOS transistor of the second inverter INV2 and one node of the PMOS transistor of the first isolation circuit ISO1 may be configured to share the first source/drain pattern SD1 and may be connected in common to the first back-side active contact BAC1.

The second back-side active contact BAC2 may be provided to penetrate the substrate 105 and connect the second lower power line VPR2 to the second source/drain pattern SD2, which is provided between the second dummy gate electrode DG2 and the second gate electrode GE2. The second back-side gate contact BGC1 may be provided to penetrate the substrate 105 and connect the second lower power line VPR2 to the second dummy gate electrode DG2. Thus, the NMOS transistor constituting the first isolation circuit ISO1 may be turned off.

One node of the NMOS transistor of the second inverter INV2 and one node of the NMOS transistor of the first isolation circuit ISO1 may be configured to share the second source/drain pattern SD2 and may be connected in common to the second back-side active contact BAC2.

A third back-side active contact BAC3 may be provided to penetrate the substrate 105 and connect the first lower power line VPR1 to the first source/drain pattern SD1, which is placed beside the third dummy gate electrode DG3. A third back-side gate contact BGC3 may be provided to penetrate the substrate 105 and connect the first lower power line VPR1 to the third dummy gate electrode DG3. A portion of the third back-side gate contact BGC3 may contact a portion of the third back-side active contact BAC3. Thus, the PMOS transistor constituting the second isolation circuit ISO2 may be turned off.

A fourth back-side active contact BAC4 may be provided to penetrate the substrate 105 and connect the second lower power line VPR2 to the second source/drain pattern SD2, which is placed beside the fourth dummy gate electrode DG4. A fourth back-side gate contact BGC4 may be provided to penetrate the substrate 105 and connect the second lower power line VPR2 to the fourth dummy gate electrode DG4. A portion of the fourth back-side gate contact BGC4 may contact a portion of the fourth back-side active contact BAC4. Thus, the NMOS transistor constituting the first isolation circuit ISO1 may be turned off.

In an embodiment, all the PMOS and NMOS transistors constituting the first and second isolation circuits ISO1 and ISO2 may be turned off, and thus, the first and second channel patterns CH1 and CH2 of the first and second inverters INV1 and INV2, which are adjacent to each other, may be electrically separated from each other.

In an embodiment, the first to fourth back-side gate contacts BGC1, BGC2, BGC3, and BGC4 may be provided to penetrate the etch stop layer ESL and may be in direct contact with the first inner electrodes PO1, respectively, which are the lowermost inner electrodes of the first to fourth dummy gate electrodes DG1, DG2, DG3, and DG4. Side surfaces of the first to fourth back-side gate contacts BGC1, BGC2, BGC3, and BGC4 may be in partial contact with side surfaces of the first to fourth back-side active contacts BAC1, BAC2, BAC3, and BAC4, respectively.

An input signal IN may be applied to the first gate electrode GE1. In an embodiment, the input signal IN may be applied to the first gate electrode GE1 through a first conductive line M1.

The first active contact AC1 of the first inverter INV1 may be connected to the second gate electrode GE2 through a second conductive line M2. In other words, an output terminal of the first inverter INV1 may be connected to an input terminal of the second inverter INV2.

An output signal OUT of the second inverter INV2 may be output to a third conductive line M3 through the second active contact AC2 of the second inverter INV2.

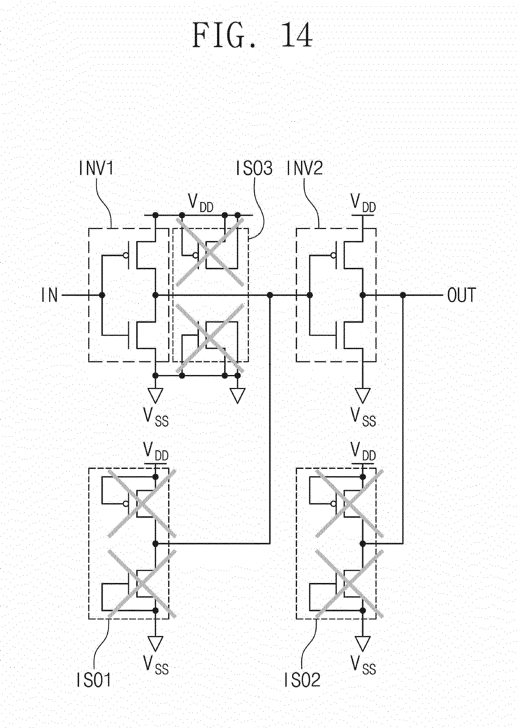

FIG. 14 is a circuit diagram illustrating a portion of a semiconductor device according to an embodiment of the inventive concept.

Referring to FIG. 14, a semiconductor device may include the first and second inverters INV1 and INV2 and first, second, and third isolation circuits ISO1, ISO2, and ISO3. In the present embodiment, two inverters are illustrated to be connected in series, but the inventive concept is not limited to this example; for example, the semiconductor device may be provided to have even-numbered inverters greater than two. Furthermore, three isolation circuits are illustrated, but the inventive concept is not limited to this example; for example, the semiconductor device may be provided to have more than three isolation circuits.

Each of the first, second, and third isolation circuits ISO1, ISO2, and ISO3 may be composed of a PMOS transistor and an NMOS transistor. An output terminal of the first isolation circuit ISO1 may be connected to an output terminal of the first inverter INV1. An output terminal of the second isolation circuit ISO2 may be connected to an output terminal of the second inverter INV2. In the third isolation circuit ISO3, gate and source/drain terminals of the PMOS transistor may be connected in common to one node of the PMOS transistor of the first inverter INV1. In the third isolation circuit ISO3, gate and source/drain terminals of the NMOS transistor may be connected in common to one node of the NMOS transistor of the first inverter INV1.

The power voltage VDD may be applied to one node of the PMOS transistor of each of the first, second, and third isolation circuits ISO1, ISO2, and ISO3, and the ground voltage VSS may be applied to one node of the NMOS transistor of each of the first, second, and third isolation circuits ISO1, ISO2, and ISO3. The power voltage VDD may be applied to a gate terminal of the PMOS transistor of each of the first, second, and third isolation circuits ISO1, ISO2, and ISO3, and the ground voltage VSS may be applied to a gate terminal of the NMOS transistor of each of the first, second, and third isolation circuits ISO1, ISO2, and ISO3. As a result, the PMOS and NMOS transistors constituting the first, second, and third isolation circuits ISO1, ISO2, and ISO3 may be turned off.

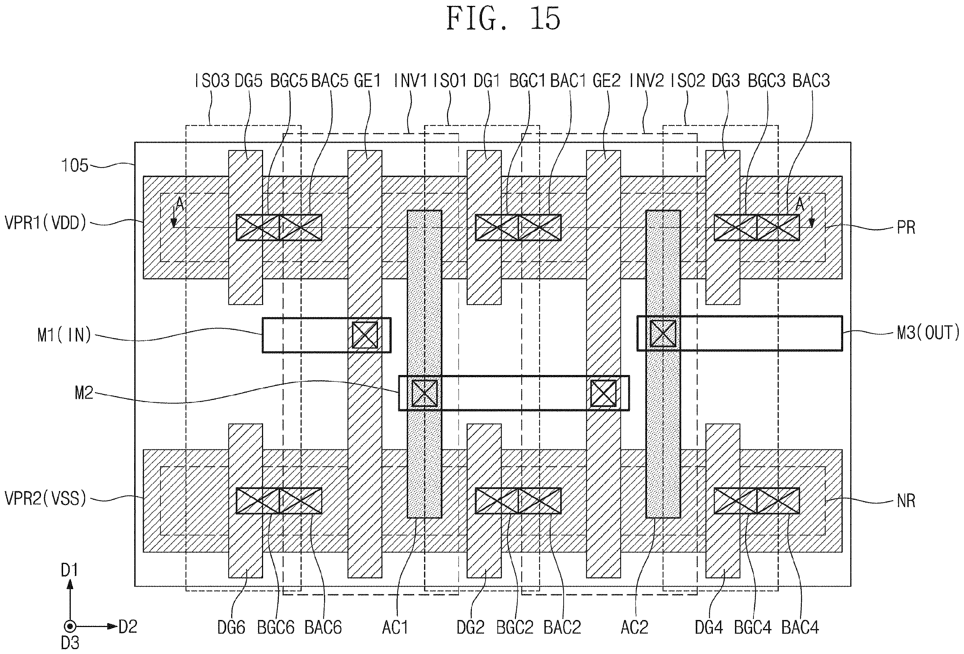

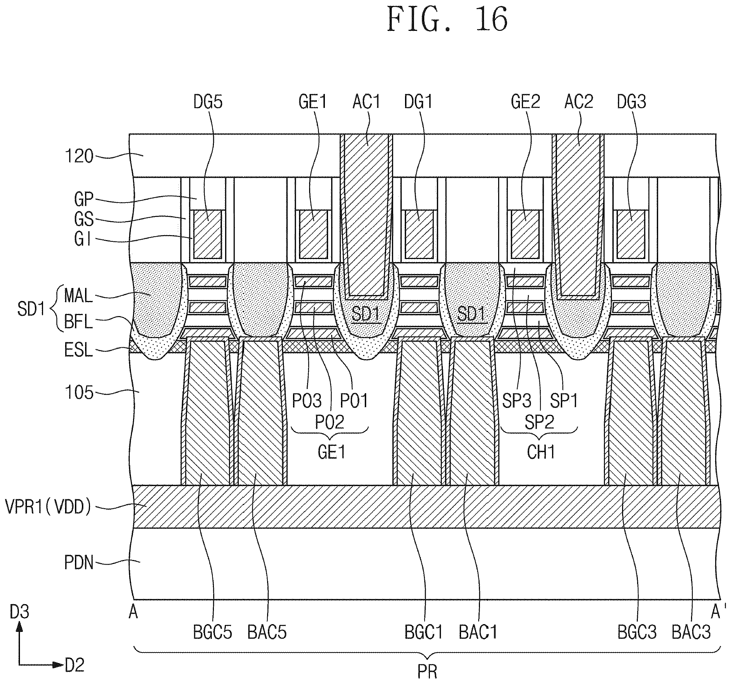

FIG. 15 is a plan view illustrating a portion of a semiconductor device according to an embodiment of the inventive concept (e.g., corresponding to a layout according to the circuit diagram of FIG. 14). FIG. 16 is a sectional view taken along a line A-A' of FIG. 15. For brevity, a previously described element may be identified by the same reference number without repeating an overlapping description thereof.

Referring to FIGS. 14, 15, and 16, the first and second inverters INV1 and INV2 and the first, second, and third isolation circuits ISO1, ISO2, and ISO3 may be provided on the substrate 105. The first inverter INV1 may be disposed between the first and third isolation circuits ISO1 and ISO3, the first isolation circuit ISO1 may be disposed between the first and second inverters INV1 and INV2, and the second inverter INV2 may be disposed between the first and second isolation circuits ISO1 and ISO2.

The first and second gate electrodes GE1 and GE2 may be extended in the first direction D1 to cross the PMOSFET and NMOSFET regions PR and NR. The first and second gate electrodes GE1 and GE2 may be disposed to cross the first and second channel patterns CH1 and CH2.

The first gate electrode GE1 may be disposed between the first dummy gate electrode DG1 and a fifth dummy gate electrode DG5 in the PMOSFET region PR and between the second dummy gate electrode DG2 and a sixth dummy gate electrode DG6 in the NMOSFET region NR. The second gate electrode GE2 may be disposed between the first dummy gate electrode DG1 and the third dummy gate electrode DG3 in the PMOSFET region PR and between the second dummy gate electrode DG2 and the fourth dummy gate electrode DG4 in the NMOSFET region NR.

The first dummy gate electrode DG1 may be disposed on the PMOSFET region PR between the first and second gate electrodes GE1 and GE2. The second dummy gate electrode DG2 may be disposed on the NMOSFET region NR between the first and second gate electrodes GE1 and GE2. The second dummy gate electrode DG2 may be spaced apart from the first dummy gate electrode DG1 in the first direction D 1.

The third dummy gate electrode DG3 may be disposed on a portion of the PMOSFET region PR, which is placed at a side of the second gate electrode GE2. The fourth dummy gate electrode DG4 may be disposed on a portion of the NMOSFET region NR, which is placed at a side of the second gate electrode GE2. The fourth dummy gate electrode DG4 may be spaced apart from the third dummy gate electrode DG3 in the first direction D1.

The fifth dummy gate electrode DG5 may be disposed on a portion of the PMOSFET region PR, which is placed at an opposite side of the first gate electrode GE1, the opposite side of the first gate electrode GE1 being the side farthest from the second gate electrode GE2 in the second direction D2. The sixth dummy gate electrode DG6 may be disposed on a portion of the NMOSFET region NR, which is placed at an opposite side of the first gate electrode GE1. The sixth dummy gate electrode DG6 may be spaced apart from the fifth dummy gate electrode DG5 in the first direction D1.

In an embodiment, the first back-side active contact BAC1 may be provided to penetrate the substrate 105 and connect the first lower power line VPR1 to the first source/drain pattern SD1, which is provided between the first dummy gate electrode DG1 and the second gate electrode GE2. The first back-side gate contact BGC1 may be provided to penetrate the substrate 105 and connect the first lower power line VPR1 to the first dummy gate electrode DG1.

The second back-side active contact BAC2 may be provided to penetrate the substrate 105 and connect the second lower power line VPR2 to the second source/drain pattern SD2, which is provided between the second dummy gate electrode DG2 and the second gate electrode GE2. The second back-side gate contact BGC2 may be provided to penetrate the substrate 105 and connect the second lower power line VPR2 to the second dummy gate electrode DG2.

The third back-side active contact BAC3 may be provided to penetrate the substrate 105 and connect the first lower power line VPR1 to the first source/drain pattern SD1, which is placed beside the third dummy gate electrode DG3. The third back-side gate contact BGC3 may be provided to penetrate the substrate 105 and connect the first lower power line VPR1 to the third dummy gate electrode DG3.

The fourth back-side active contact BAC4 may be provided to penetrate the substrate 105 and connect the second lower power line VPR2 to the second source/drain pattern SD2, which is placed beside the fourth dummy gate electrode DG4. The fourth back-side gate contact BGC4 may be provided to penetrate the substrate 105 and connect the second lower power line VPR2 to the fourth dummy gate electrode DG4.

A fifth back-side active contact BAC5 may be provided to penetrate the substrate 105 and connect the first lower power line VPR1 to the first source/drain pattern SD1, which is placed beside the fifth dummy gate electrode DG5. A fifth back-side gate contact BGC5 may be provided to penetrate the substrate 105 and connect the first lower power line VPR1 to the fifth dummy gate electrode DG5.

A sixth back-side active contact BAC6 may be provided to penetrate the substrate 105 and connect the second lower power line VPR2 to the second source/drain pattern SD1, which is placed beside the sixth dummy gate electrode DG6. A sixth back-side gate contact BGC6 may be provided to penetrate the substrate 105 and connect the second lower power line VPR2 to the sixth dummy gate electrode DG6.

One node of the PMOS transistor of the first inverter INV1 and one node of the PMOS transistor of the third isolation circuit ISO3 may be configured to share the first source/drain pattern SD1 and may be connected in common to the fifth back-side active contact BAC5.

One node of the NMOS transistor of the first inverter INV1 and one node of the NMOS transistor of the third isolation circuit ISO3 may be configured to share the first source/drain pattern SD1 and may be connected in common to the sixth back-side active contact BAC6.

The power voltage VDD may be applied to one node and a gate terminal of the PMOS transistor constituting each of the first, second, and third isolation circuits ISO1, ISO2, and ISO3. The ground voltage VSS may be applied to one node and a gate terminal of the NMOS transistor constituting each of the first, second, and third isolation circuits ISO1, ISO2, and ISO3. Thus, the PMOS and NMOS transistors constituting the first, second, and third isolation circuits ISO1, ISO2, and ISO3 may be turned off, and thus, the first and second channel patterns CH1 and CH2 of the first and second inverters INV1 and INV2, which are adjacent to each other, may be electrically separated from each other.

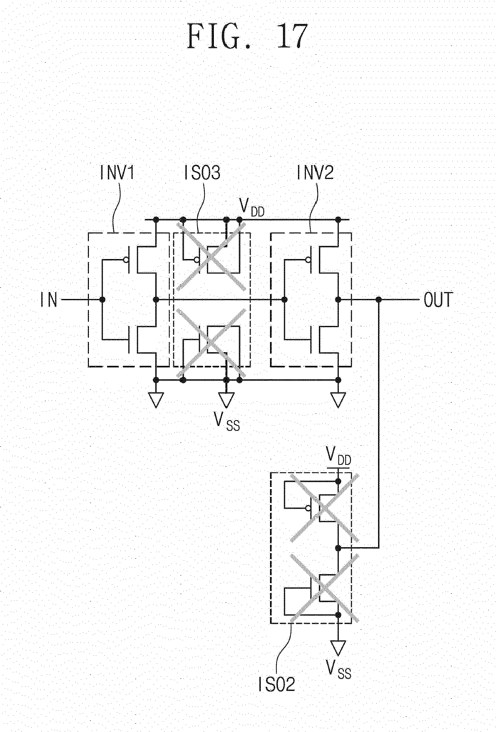

FIG. 17 is a circuit diagram illustrating a portion of a semiconductor device according to an embodiment of the inventive concept.

Referring to FIG. 17, the first isolation circuit ISO1 in the embodiment of FIG. 14 may be omitted from the semiconductor device in the present embodiment. In other words, the semiconductor device may include the first and second inverters INV1 and INV2 and the second and third isolation circuits ISO2 and ISO3.

The power voltage VDD may be applied to one node of the PMOS transistor of each of the second and third isolation circuits ISO2 and ISO3, and the ground voltage VSS may be applied to one node of the NMOS transistor of each of the second and third isolation circuits ISO2 and ISO3. The power voltage VDD may be applied to a gate terminal of the PMOS transistor of each of the first and second isolation circuits ISO1 and ISO2, and the ground voltage VSS may be applied to a gate terminal of the NMOS transistor of each of the first and second isolation circuits ISO1 and ISO2. As a result, the PMOS and NMOS transistors constituting the second and third isolation circuits ISO2 and ISO3 may be turned off.

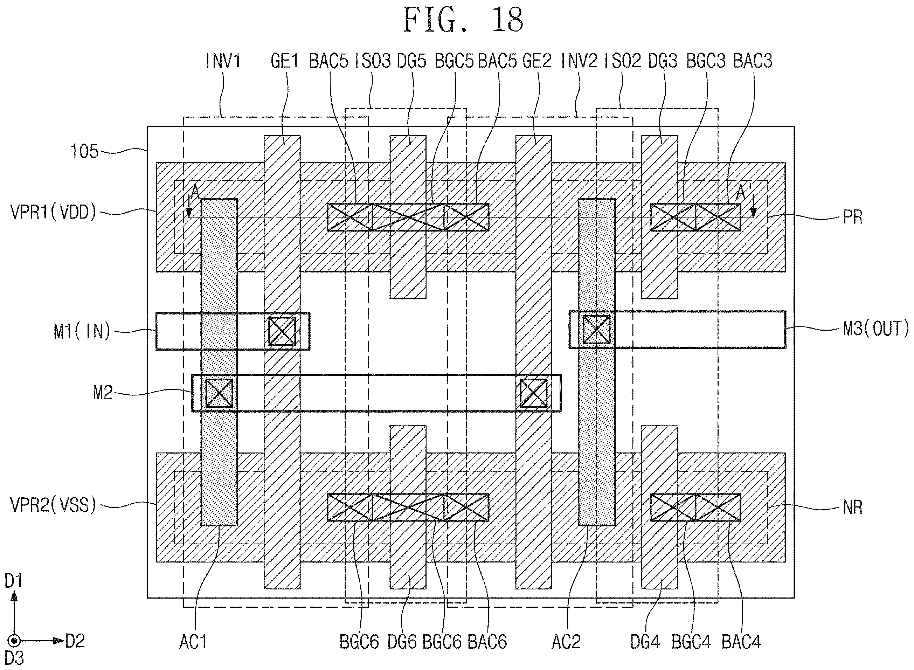

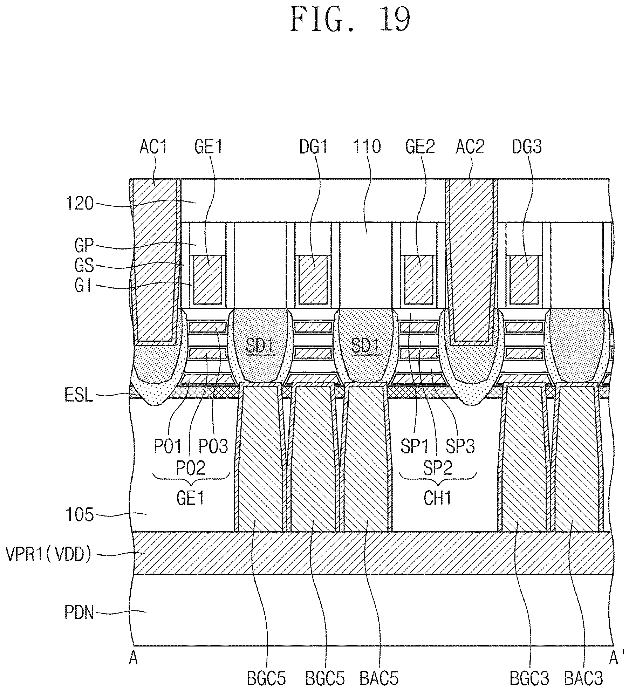

FIG. 18 is a plan view illustrating a portion of a semiconductor device according to an embodiment of the inventive concept (e.g., corresponding to a layout according to the circuit diagram of FIG. 17). FIG. 19 is a sectional view taken along a line A-A' of FIG. 18. For brevity, an element described with reference to FIGS. 15 and 16 may be identified by the same reference number without repeating an overlapping description thereof.

Referring to FIGS. 17, 18, and 19, the first and second inverters INV1 and INV2 and the second and third isolation circuits ISO2 and ISO3 may be provided on the substrate 105. The third isolation circuit ISO3 may be disposed between the first and second inverters INV1 and INV2, and the second inverter INV2 may be disposed between the third and second isolation circuits ISO3 and ISO2.

The fifth and sixth dummy gate electrodes DG5 and DG6 of the third isolation circuit ISO3 may be disposed between the first gate electrode GE1 and the second gate electrode GE2 and may be spaced apart from each other in the first direction D1.

The fifth dummy gate electrode DG5 may be disposed on the PMOSFET region PR between the first and second gate electrodes GE1 and GE2. The sixth dummy gate electrode DG6 may be disposed on the NMOSFET region NR between the first and second gate electrodes GE1 and GE2.

The first active contact AC1 may be disposed at an opposite side of the first gate electrode GE1 and may be electrically connected to the first and second source/drain patterns SD1 and SD2. The opposite side of the first gate electrode GE1 may be the side of the first gate electrode GE1 farthest from the second gate electrode GE2 in the second direction D2. The second active contact AC2 may be disposed at a side of the second gate electrode GE2 facing the third dummy gate electrode DG3 and may be electrically connected to the first and second source/drain patterns SD1 and SD2.

The fifth back-side active contacts BAC5 may connect the first lower power line VPR1 to the first source/drain patterns SD1, which are provided between the first gate electrode GE1 and the fifth dummy gate electrode DG5, and may connect the first lower power line VPR1 to the first source/drain patterns SD1, which are provided between the second gate electrode GE2 and the fifth dummy gate electrode DG5.

The fifth back-side gate contact BGC5 may be provided to penetrate the substrate 105 and connect the first lower power line VPR1 to the fifth dummy gate electrode DG5. The fifth back-side gate contact BGC5 may be electrically connected in common to the fifth back-side active contacts BAC5, which are disposed at both sides thereof. Opposite side surfaces of the fifth back-side gate contact BGC5 may be in direct contact with side surfaces of the fifth back-side active contacts BAC5.

The sixth back-side active contacts BAC6 may connect the second lower power line VPR2 to the second source/drain patterns SD2, which are provided between the first gate electrode GE1 and the sixth dummy gate electrode DG6, and may connect the second lower power line VPR2 to the second source/drain patterns SD2, which are provided between the second gate electrode GE2 and the sixth dummy gate electrode DG6.

A sixth back-side gate contact BGC6 may be provided to penetrate the substrate 105 and connect the second lower power line VPR2 to the sixth dummy gate electrode DG6. The sixth back-side gate contact BGC6 may be electrically connected in common to the sixth back-side active contacts BAC6, which are disposed at both sides thereof. Opposite side surfaces of the sixth back-side gate contact BGC6 may be in direct contact with side surfaces of the sixth back-side active contacts BAC6.

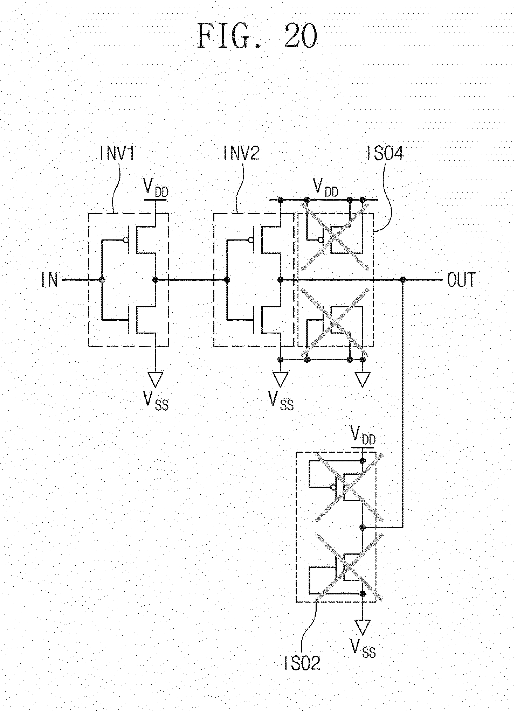

FIG. 20 is a circuit diagram illustrating a portion of a semiconductor device according to an embodiment of the inventive concept.

Referring to FIG. 20, a semiconductor device may include the first and second inverters INV1 and INV2 and second and fourth isolation circuits ISO2 and ISO4.

Each of the second and fourth isolation circuits ISO2 and ISO4 may be composed of a PMOS transistor and an NMOS transistor. An output terminal of the second isolation circuit ISO2 may be connected to an output terminal of the second inverter INV2. In the second isolation circuit ISO2, gate and source/drain terminals of the PMOS transistor may be connected in common to one node of the PMOS transistor of the second inverter INV2. In the fourth isolation circuit ISO4, gate and source/drain terminals of the NMOS transistor may be connected in common to one node of the NMOS transistor of the second inverter INV2.

The power voltage VDD may be applied to one node of the PMOS transistor of each of the second and fourth isolation circuits ISO2 and ISO4, and the ground voltage VSS may be applied to one node of the NMOS transistor of each of the second and fourth isolation circuits ISO2 and ISO4. The power voltage VDD may be applied to a gate terminal of the PMOS transistor of each of the second and fourth isolation circuits ISO2 and ISO4, and the ground voltage VSS may be applied to a gate terminal of the NMOS transistor of each of the second and fourth isolation circuits ISO2 and ISO4. As a result, the PMOS and NMOS transistors constituting the second and fourth isolation circuits ISO2 and ISO4 may be turned off.

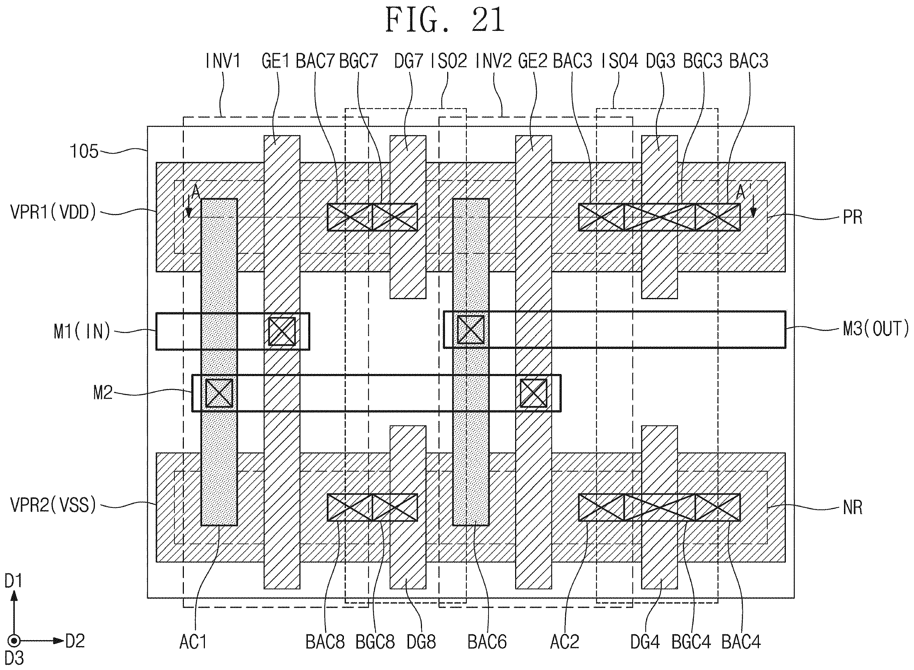

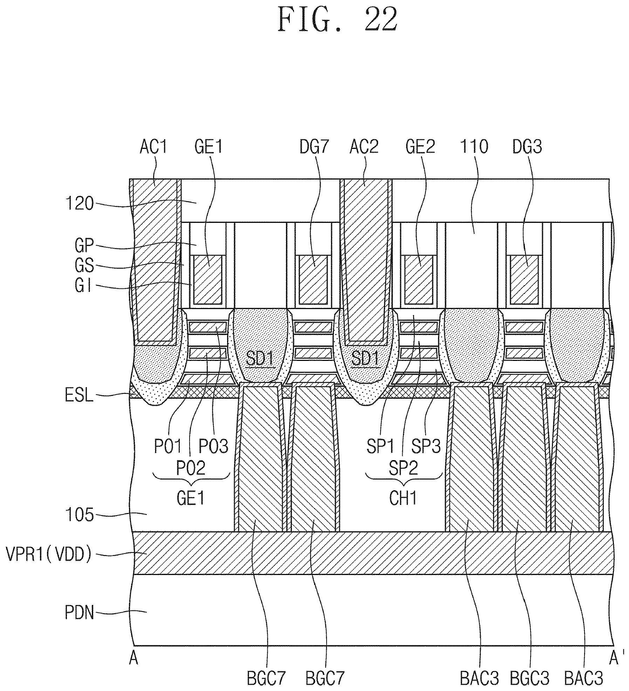

FIG. 21 is a plan view illustrating a portion of a semiconductor device according to an embodiment of the inventive concept (e.g., a layout according to the circuit diagram of FIG. 20). FIG. 22 is a sectional view taken along a line A-A' of FIG. 21. For brevity, a previously described element may be identified by the same reference number without repeating an overlapping description thereof.

Referring to FIGS. 20, 21, and 22, the first and second inverters INV1 and INV2 and the second and fourth isolation circuits ISO2 and ISO4 may be provided on the substrate 105. The second isolation circuit ISO2 may be disposed between the first and second inverters INV1 and INV2, and the second inverter INV2 may be disposed between the fourth and second isolation circuits ISO2 and ISO4.

In an embodiment, seventh and eighth dummy gate electrodes DG7 and DG8 of the second isolation circuit ISO2 may be disposed between the first gate electrode GE1 and the second gate electrode GE2 and may be spaced apart from each other in the first direction D1. The seventh dummy gate electrode DG7 may be disposed on the PMOSFET region PR between the first and second gate electrodes GE1 and GE2. The eighth dummy gate electrode DG8 may be disposed on the NMOSFET region NR between the first and second gate electrodes GE1 and GE2.

The first active contact AC1 may be disposed at an opposite side of the first gate electrode GE1 and may be electrically connected to the first and second source/drain patterns SD1 and SD2. The second active contact AC2 may be disposed at an opposite side of the second gate electrode GE2 and may be electrically connected to the first and second source/drain patterns SD1 and SD2. The opposite side of the second gate electrode GE2 may be adj acent to the third and fourth dummy gate electrodes DG3 and DG4.

The third back-side active contacts BAC3 may connect the first lower power line VPR1 to the first source/drain patterns SD1, which are provided between the second gate electrode GE2 and the third dummy gate electrode DG3, and may connect the first lower power line VPR1 to the first source/drain pattern SD1, which is disposed at a side of the third dummy gate electrode DG3 facing away from the second gate electrode GE2.

The third back-side gate contact BGC3 may be provided to penetrate the substrate 105 and connect the first lower power line VPR1 to the third dummy gate electrode DG3. The third back-side gate contact BGC3 may be electrically connected in common to the third back-side active contacts BAC3, which are disposed at both sides thereof. Opposite side surfaces of the third back-side gate contact BGC3 may be in direct contact with side surfaces of the third back-side active contacts BAC3.

The fourth back-side active contacts BAC4 may connect the second lower power line VPR2 to the second source/drain patterns SD2, which are provided between the second gate electrode GE2 and the fourth dummy gate electrode DG4, and may connect the second lower power line VPR2 to the second source/drain pattern SD2, which is disposed at a side of the fourth dummy gate electrode DG4 facing away from the second gate electrode GE2.

The fourth back-side gate contact BGC4 may be provided to penetrate the substrate 105 and connect the second lower power line VPR2 to the fourth dummy gate electrode DG4. The fourth back-side gate contact BGC4 may be electrically connected in common to the fourth back-side active contacts BAC4, which are disposed at both sides thereof. Opposite side surfaces of the fourth back-side gate contact BGC4 may be in direct contact with the side surfaces of the fourth back-side active contacts BAC4.

A seventh back-side active contact BAC7 may connect the first lower power line VPR1 to the first source/drain patterns SD1, which are provided between the first gate electrode GE1 and the seventh dummy gate electrode DG7.

A seventh back-side gate contact BGC7 may be provided to penetrate the substrate 105 and connect the first lower power line VPR1 to the seventh dummy gate electrode DG7. The seventh back-side gate contact BGC7 may be in direct contact with the seventh back-side active contact BAC7.

An eighth back-side active contact BAC8 may connect the second lower power line VPR2 to the second source/drain patterns SD2, which are provided between the first gate electrode GE1 and the eighth dummy gate electrode DG8.

An eighth back-side gate contact BGC8 may be provided to penetrate the substrate 105 and connect the second lower power line VPR2 to the eighth dummy gate electrode DG8. The eighth back-side gate contact BGC8 may be in direct contact with the eighth back-side active contact BAC8.

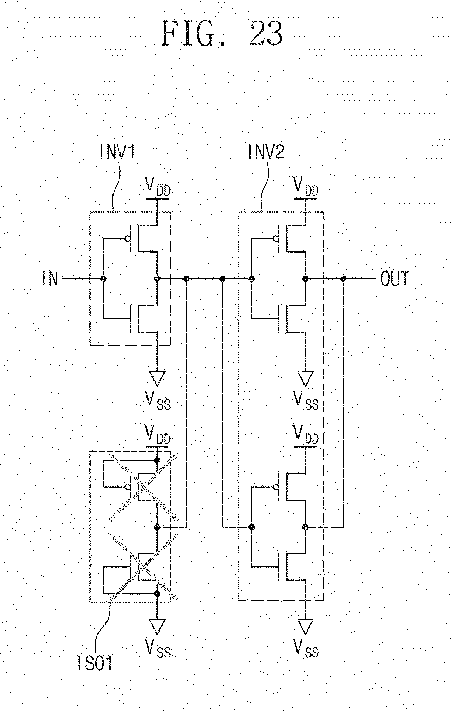

FIG. 23 is a circuit diagram illustrating a portion of a semiconductor device according to an embodiment of the inventive concept.

Referring to FIG. 23, a semiconductor device may include the first and second inverters INV1 and INV2 and the first isolation circuit ISO1.

The first inverter INV1 may be composed of a PMOS transistor and an NMOS transistor. The second inverter INV2 may have a driving ability different from the first inverter INV1. The second inverter INV2 may be composed of two sub-inverters, which are connected in parallel. In other words, the second inverter INV2 may include two PMOS transistors and two NMOS transistors.

An output terminal of the first inverter INV1 may be connected to an input terminal of the two sub-inverters of the second inverter INV2. Output terminals of the two sub-inverters of the second inverter INV2 may be electrically connected in common.

An output terminal of the first isolation circuit ISO1 may be connected to an output terminal of the first inverter INV1. The power voltage VDD may be applied to one node and a gate terminal of the PMOS transistor of the first isolation circuit ISO1, and the ground voltage VSS may be applied to one node and a gate terminal of the NMOS transistor of the first isolation circuit ISO1. Thus, the PMOS and NMOS transistors constituting the first isolation circuit ISO1 may be turned off.

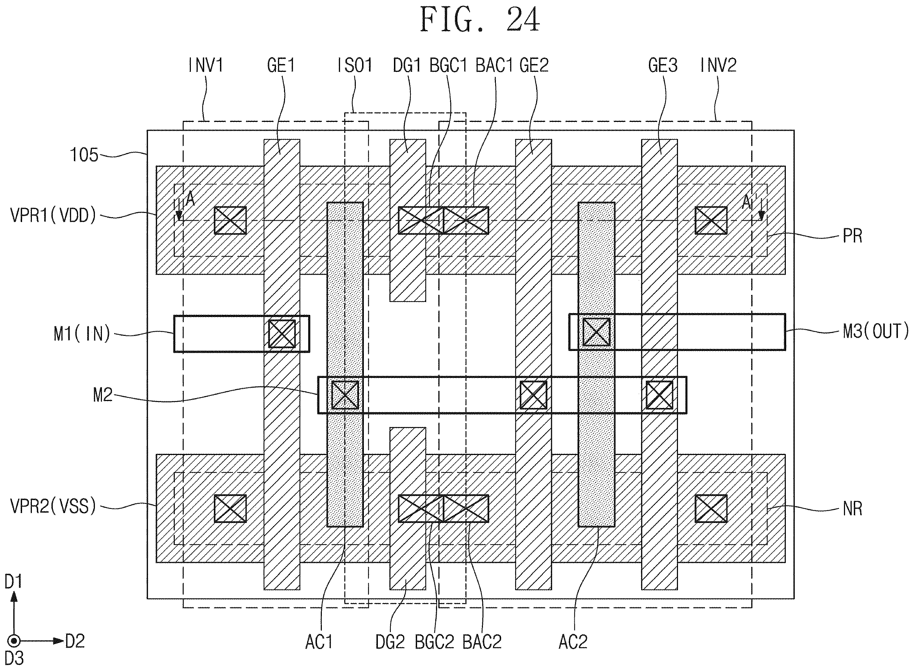

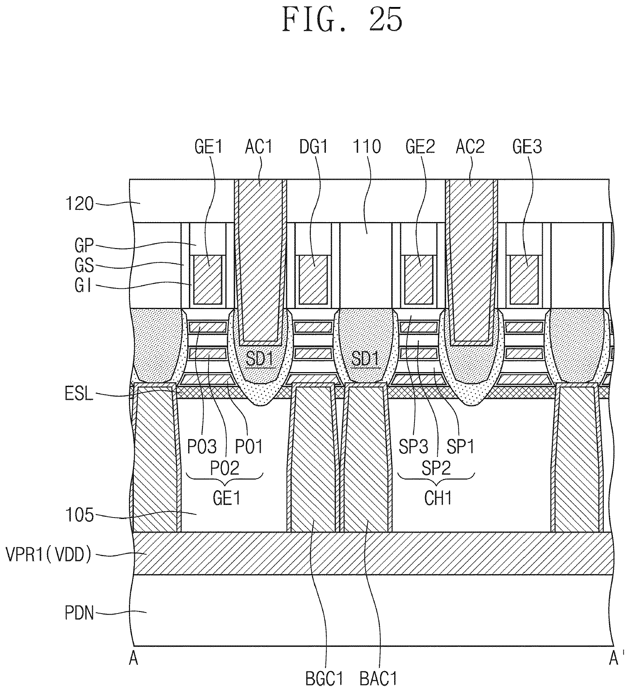

FIG. 24 is a plan view illustrating a portion of a semiconductor device according to an embodiment of the inventive concept (e.g., a layout according to the circuit diagram of FIG. 23). FIG. 25 is a sectional view taken along a line A-A' of FIG. 24. For brevity, a previously described element may be identified by the same reference number without repeating an overlapping description thereof.

Referring to FIGS. 23, 24, and 25, the first and second inverters INV1 and INV2 and the first and second isolation circuits ISO1 and ISO2 may be provided on the substrate 105. The first isolation circuit ISO1 may be disposed between the first and second inverters INV1 and INV2.

First, second, and third gate electrodes GE1, GE2, and GE3 may be extended in the first direction D1 to cross the PMOSFET and NMOSFET regions PR and NR. The first, second, and third gate electrodes GE1, GE2, and GE3 may be disposed to cross the first and second channel patterns CH1 and CH2. The third gate electrode GE3 may include the first inner electrode PO1, the second inner electrode PO2, the third inner electrode PO3, and the outer electrode PO4, similar to the first and second gate electrodes GE1 and GE2.

The first dummy gate electrode DG1 may be disposed on the PMOSFET region PR between the first and second gate electrodes GE1 and GE2. The second dummy gate electrode DG2 may be disposed on the NMOSFET region NR between the first and second gate electrodes GE1 and GE2. The second dummy gate electrode DG2 may be spaced apart from the first dummy gate electrode DG1 in the first direction D1.

The first active contact AC1 may be electrically connected to the first and second source/drain patterns SD1 and SD2, which are provided between the first gate electrode GE1 and the first dummy gate electrode DG1.

The second active contact AC2 may be electrically connected to the first and second source/drain patterns SD1 and SD2, which are provided between the second gate electrode GE2 and the third gate electrode GE3.

The first back-side active contact BAC1 may be provided to penetrate the substrate 105 and connect the first lower power line VPR1 to the first source/drain pattern SD1, which is provided between the first dummy gate electrode DG1 and the second gate electrode GE2. The first back-side gate contact BGC1 may be provided to penetrate the substrate 105 and connect the first lower power line VPR1 to the first dummy gate electrode DG1.

The second back-side active contact BAC2 may be provided to penetrate the substrate 105 and connect the second lower power line VPR2 to the second source/drain pattern SD2, which is provided between the second dummy gate electrode DG2 and the second gate electrode GE2. The second back-side gate contact BGC2 may be provided to penetrate the substrate 105 and connect the second lower power line VPR2 to the second dummy gate electrode DG2.

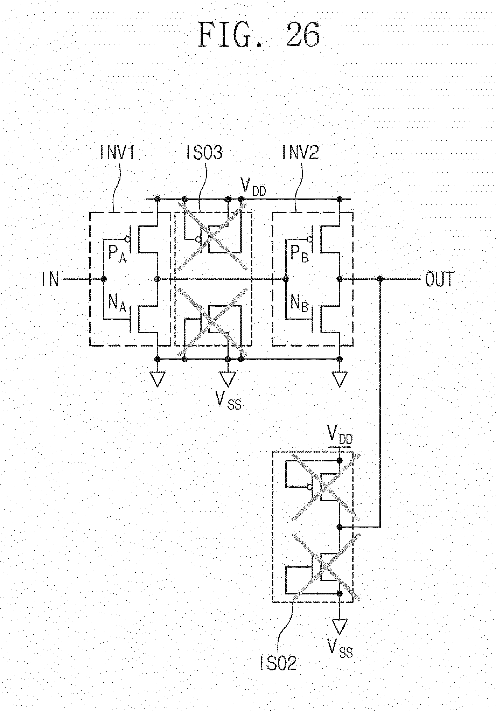

FIG. 26 is a circuit diagram illustrating a portion of a semiconductor device according to an embodiment of the inventive concept.

Referring to FIG. 26, a semiconductor device may include the first and second inverters INV1 and INV2 and the second and third isolation circuits ISO2 and ISO3, similar to the embodiment of FIG. 17. Here, the second inverter INV2 may have a driving ability different from that of the first inverter INV1. As an example, the second inverter INV2 may include PMOS and NMOS transistors, which have larger sizes than the PMOS and NMOS transistors of the first inverter INV1. Effective channel widths PB and NB of the PMOS and NMOS transistors of the second inverter INV2 may be larger than effective channel widths PA and NA of the PMOS and NMOS transistors of the first inverter INV1.

The second isolation circuit ISO2 may be connected to an output terminal of the second inverter INV2, the power voltage VDD may be applied to one node and a gate terminal of the PMOS transistor, and the ground voltage VSS may be applied to one node and a gate terminal of the NMOS transistor. Thus, the PMOS and NMOS transistors constituting the third isolation circuit ISO3 may be turned off.

In the third isolation circuit ISO3, gate and source/drain terminals of the PMOS transistor may be connected in common to one node of the PMOS transistor of the first inverter INV1. In the third isolation circuit ISO3, gate and source/drain terminals of the NMOS transistor may be connected in common to one node of the NMOS transistor of the first inverter INV1.

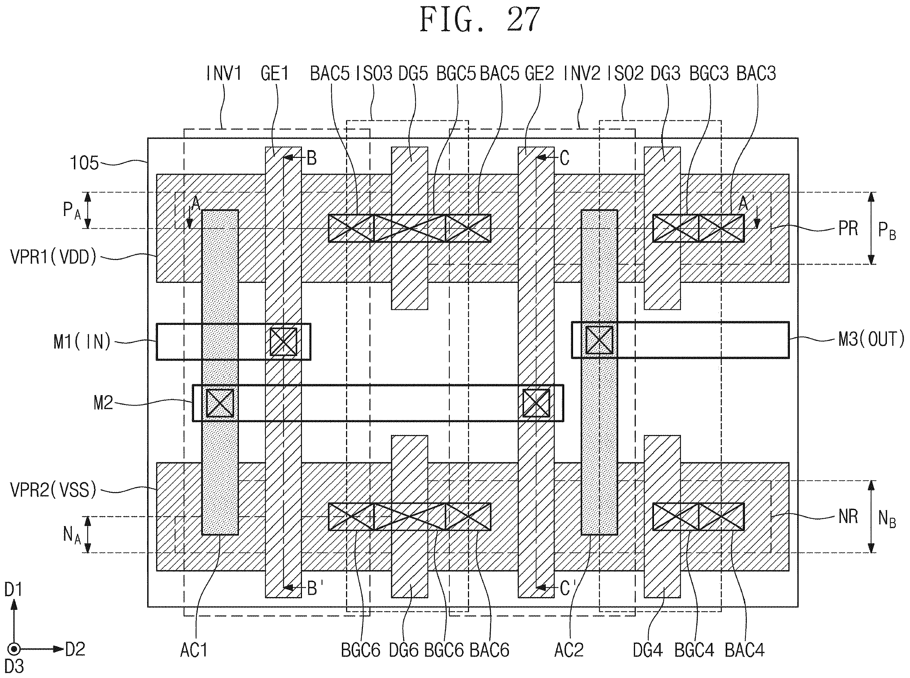

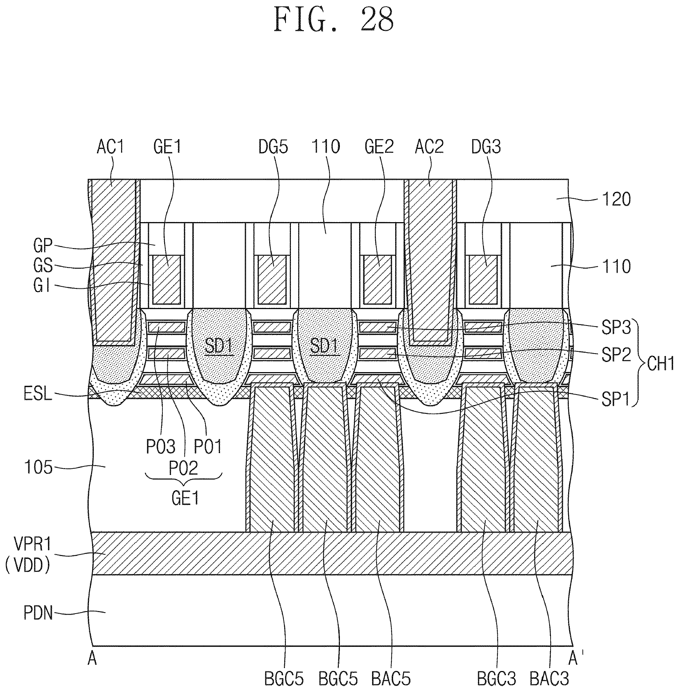

FIG. 27 is a plan view illustrating a portion of a semiconductor device according to an embodiment of the inventive concept. FIGS. 28, 29, and 30 are sectional views taken along lines A-A', B-B', and C-C' of FIG. 27.

Referring to FIGS. 26, 27, and 28, the first and second inverters INV1 and INV2 and the second and third isolation circuits ISO2 and ISO3 may be provided on the substrate 105, as described with reference to FIGS. 18 and 19.

The first and second gate electrodes GE1 and GE2 may be extended in the first direction D1 to cross the PMOSFET and NMOSFET regions PR and NR. The first and second gate electrodes GE1 and GE2 may be disposed to cross the first and second channel patterns CH1 and CH2.

In the PMOSFET region PR, the first channel patterns CH1, which are enclosed by the first gate electrode GE1 and the first dummy gate electrode DG1, may have a first channel width PA in the first direction D1. In the PMOSFET region PR, the first channel patterns CH1, which are enclosed by the second gate electrode GE2 and the third dummy gate electrode DG3, may have a second channel width PB, which is larger than the first channel width PA, in the first direction D1.

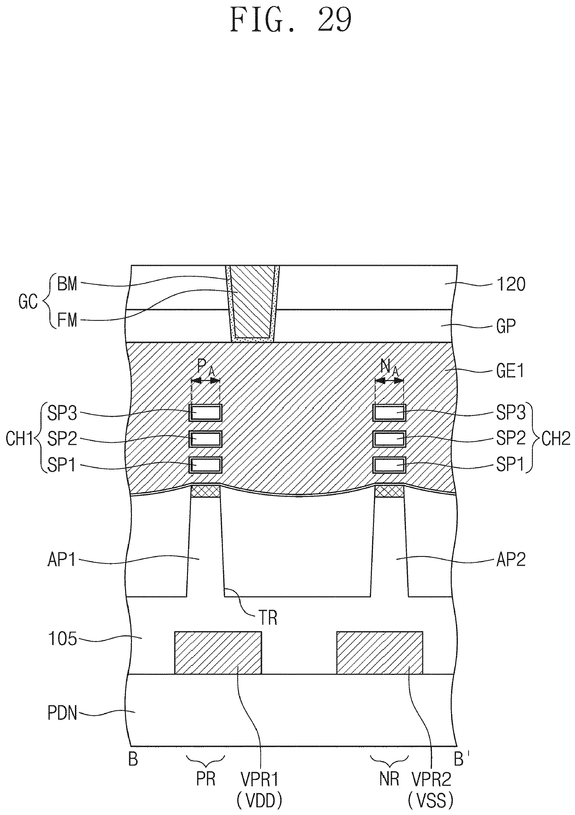

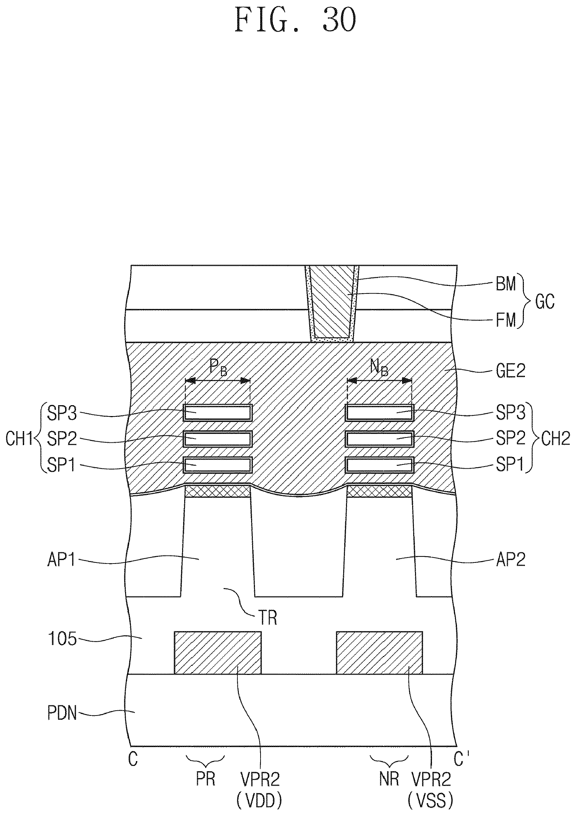

In the NMOSFET region NR, the second channel patterns CH2, which are enclosed by the first gate electrode GE1 and the second dummy gate electrode DG2, may have a third channel width NA in the first direction D1. In the NMOSFET region NR, the second channel patterns CH2, which are enclosed by the second gate electrode GE2 and the fourth dummy gate electrode DG4, may have a fourth channel width NB, which is larger than the third channel width NA, in the first direction D1. FIGS. 29 and 30 show a gate contact GC directly connected to an upper surface of the first gate electrode GE1 and the second gate electrode GE2.

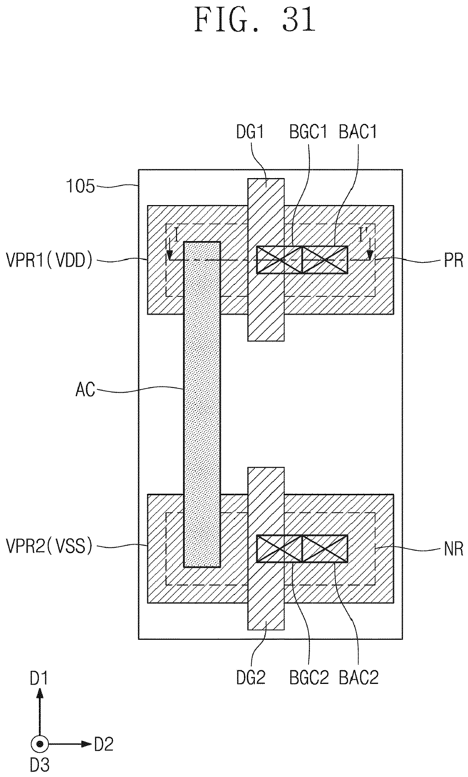

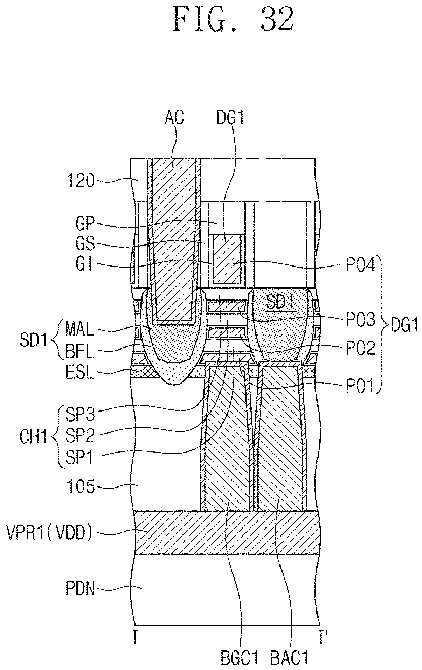

FIGS. 31, 33, 35, 37, and 39 are plan views illustrating an isolation circuit of a semiconductor device according to an embodiment of the inventive concept. FIGS. 32, 34, 36, 38, and 40 are sectional views taken along lines I-I' of FIGS. 31, 33, 35, 37, and 39, respectively. FIGS. 31 to 40 illustrate isolation circuits in the semiconductor devices according to the afore-described embodiments, and for brevity, a previously described element may be identified by the same reference number without repeating an overlapping description thereof.

Referring to FIGS. 31 and 32, in the PMOSFET region PR, the first back-side active contact BAC1 may connect the first source/drain pattern SD1, which is placed at a side of the first dummy gate electrode DG1, to the first lower power line VPR1. The first back-side gate contact BGC1 may connect the first dummy gate electrode DG1 to the first lower power line VPR1. The first lower power line VPR1 may be used to apply the power voltage VDD to the first dummy gate electrode DG1 and the first source/drain pattern SD1, which is placed at a side thereof, and thus, the PMOS transistor of the isolation circuit may be turned off.

In the NMOSFET region NR, the second back-side active contact BAC2 may connect the second source/drain pattern SD2, which is placed at a side of the second dummy gate electrode DG2, to the second lower power line VPR2. The second back-side gate contact BGC2 may connect the second dummy gate electrode DG2 to the second lower power line VPR2. The second lower power line VPR2 may be used to apply the ground voltage VSS to the second dummy gate electrode DG2 and the second source/drain pattern SD2, which is placed at a side thereof, and thus, the NMOS transistor of the isolation circuit may be turned off.

The active contact AC may be provided to penetrate the first and second interlayer insulating layers 110 and 120 and connect the first source/drain pattern SD1, which is placed at an opposite side of the first dummy gate electrode DG1 (e.g., the left side in FIG. 31), to the second source/drain pattern SD2, which is placed at an opposite side of the second dummy gate electrode DG2 (e.g., the left side in FIG. 31).

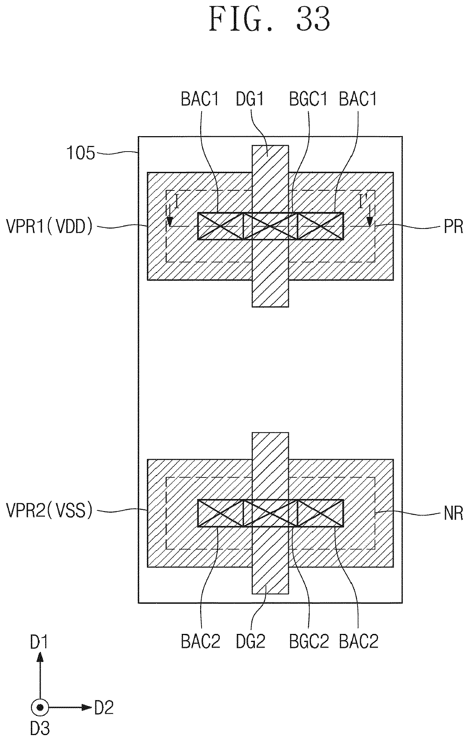

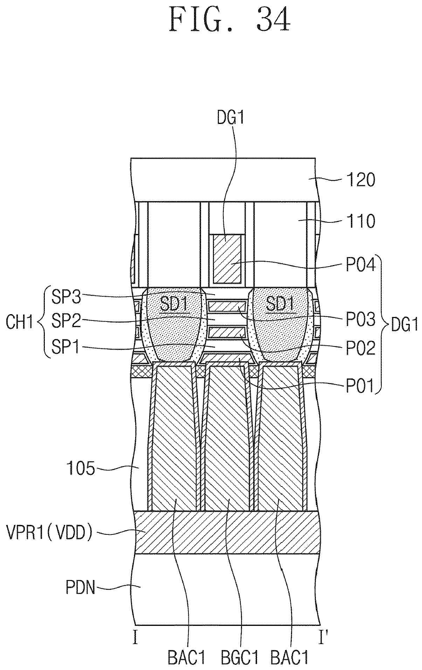

Referring to FIGS. 33 and 34, the first source/drain patterns SD1, which are disposed at both sides of the first dummy gate electrode DG1, may be connected to the first lower power line VPR1 through the first back-side active contacts BAC1. The first back-side gate contact BGC1 may connect the first dummy gate electrode DG1 to the first lower power line VPR1, and the first back-side gate contact BGC1 may have opposite side surfaces that are in direct contact with the first back-side active contacts BAC1 disposed at both sides thereof.

The second source/drain patterns SD2, which are disposed at both sides of the second dummy gate electrode DG2, may be connected to the second lower power line VPR2 through the second back-side active contacts BAC2. The second back-side gate contact BGC2 may connect the second dummy gate electrode DG2 to the second lower power line VPR2, and the second back-side gate contact BGC2 may have opposite side surfaces that are in direct contact with the second back-side active contacts BAC2 disposed at both sides thereof.

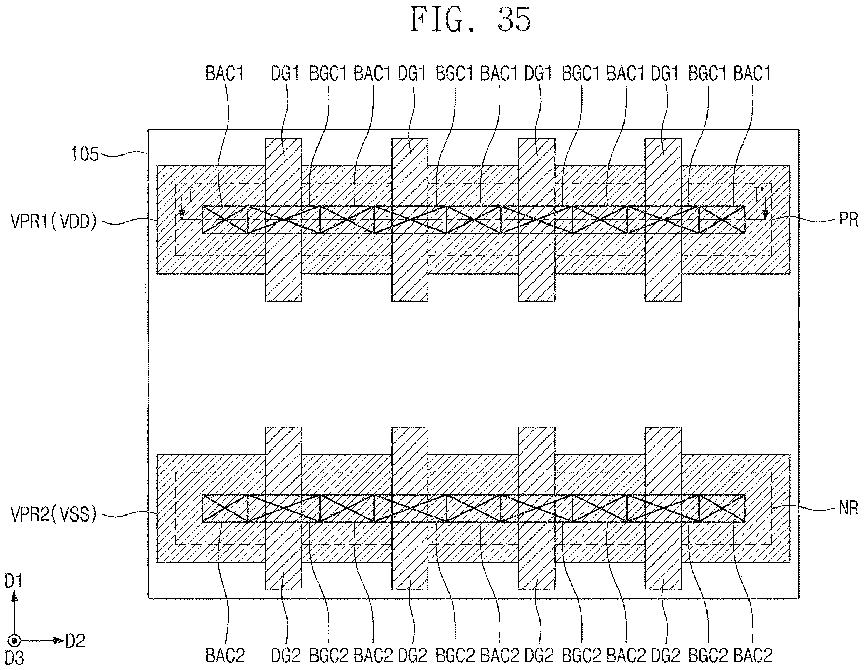

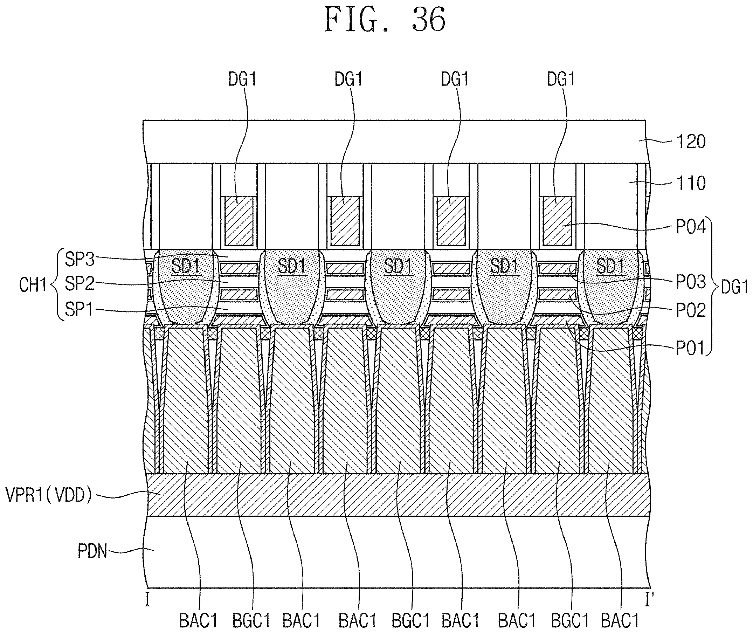

Referring to FIGS. 35 and 36, a plurality of first dummy gate electrodes DG1 may be disposed in the PMOSFET region PR to be spaced apart from each other with a constant pitch, and a plurality of second dummy gate electrodes DG2 may be disposed in the NMOSFET region NR to be spaced apart from each other with a constant pitch.

The first back-side gate contacts BGC1 may be coupled to the first dummy gate electrodes DG1, respectively, and the second back-side gate contacts BGC2 may be coupled to the second dummy gate electrodes DG2, respectively.

The first source/drain patterns SD1 may be respectively disposed between the first dummy gate electrodes DG1, and the first back-side active contacts BAC1 may be coupled to the first source/drain patterns SD1, respectively. In other words, the first back-side active contacts BAC1 and the first back-side gate contacts BGC1 may be alternately disposed to be in contact with each other, in the PMOSFET region PR.

The second source/drain patterns SD2 may be respectively disposed between the second dummy gate electrodes DG2, and the second back-side active contacts BAC2 may be coupled to the second source/drain patterns SD2, respectively. In other words, the second back-side active contacts BAC2 and the second back-side gate contacts BGC2 may be alternately disposed to be in contact with each other, in the NMOSFET region NR.

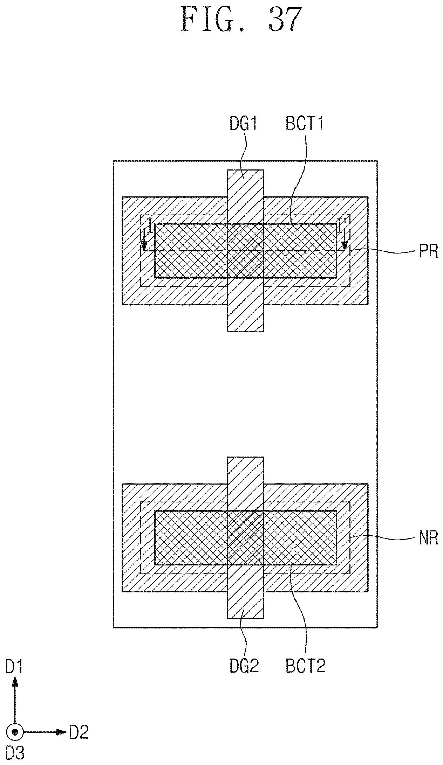

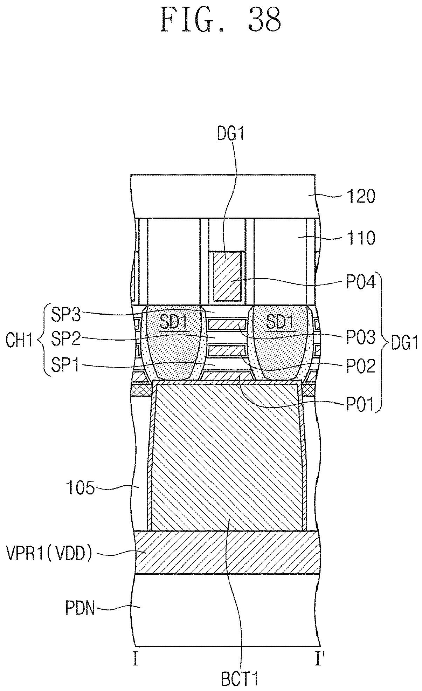

Referring to FIGS. 37 and 38, the first dummy gate electrode DG1 and the first source/drain patterns SD1, which are disposed at both sides thereof, may be connected to the first lower power line VPR1 through one first back-side contact BCT1. The first back-side contact BCT1 may have a bottom surface, which is in direct contact with the lowermost inner electrode (e.g., the first inner electrode PO1) of the first dummy gate electrode DG1 and the first source/drain patterns SD1. The bottom surface of the first back-side contact BCT1 may be non-flat or uneven.

The second dummy gate electrode DG2 and the second source/drain patterns SD2, which are disposed at both sides thereof, may be connected to the second lower power line VPR2 through one second back-side contact BCT2. The second back-side contact BCT2 may have a bottom surface, which is in direct contact with the lowermost inner electrode (e.g., the second inner electrode P02) of the second dummy gate electrode DG2 and the second source/drain patterns SD2. The bottom surface of the second back-side contact BCT2 may be non-flat or uneven.

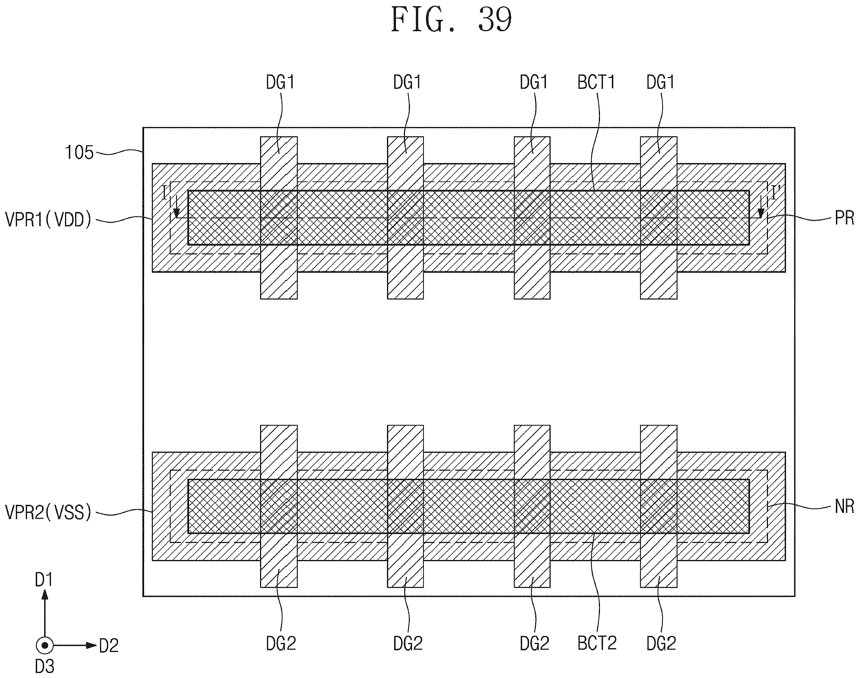

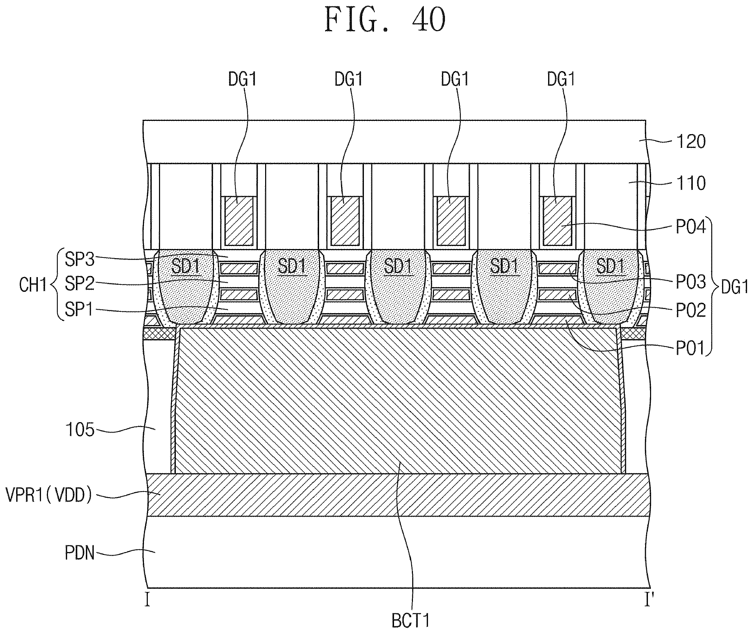

Referring to FIGS. 39 and 40, the first dummy gate electrodes DG1 and the first source/drain patterns SD1 may be alternately arranged in the PMOSFET region PR, as previously described with reference to FIGS. 35 and 36. The second dummy gate electrodes DG2 and the second source/drain patterns SD2 may be alternately arranged in the NMOSFET region NR.

One first back-side contact BCT1 may be connected in common to the first dummy gate electrodes DG1 and the first source/drain patterns SD1, and one second back-side contact BCT2 may be connected in common to the second dummy gate electrodes DG2 and the second source/drain patterns SD2. The first back-side contact BCT1 may have a non-flat or uneven bottom surface, which is in contact with the first dummy gate electrodes DG1 and the first source/drain patterns SD1, and similarly, the second back-side contact BCT2 may have a non-flat or uneven bottom surface.

According to an embodiment of the inventive concept, a dummy gate may be disposed between devices, and in this case, by applying a power voltage to the dummy gate, it is possible to isolate the devices, which are adjacent to each other and have a uniform layout, from each other.

In addition, a back-side gate contact penetrating a substrate may be used to directly connect lower power lines, which are buried in a lower portion of the substrate, to dummy gates of an isolation circuit, and in this case, it is possible to increase an integration density of a semiconductor device.

While example embodiments of the inventive concept have been particularly shown and described, it will be understood by one of ordinary skill in the art that variations in form and detail may be made thereto without departing from the spirit and scope of the inventive concept as set forth in the attached claims.

## Claims

1. A semiconductor device, comprising:
first and second transistors on a substrate;
an isolation transistor provided between the first and second transistors;
a lower power line in a lower portion of the substrate; and
a back-side gate contact penetrating the substrate and connected to the lower power line and a dummy gate electrode of the isolation transistor.

2. The semiconductor device of claim 1, wherein the isolation transistor comprises:
a channel pattern on the substrate, the channel pattern comprising a plurality of semiconductor patterns, which are stacked and spaced apart from each other;
a gate insulating layer interposed between the dummy gate electrode and the channel pattern; and
source and drain patterns connected to different portions of the channel pattern,
wherein the dummy gate electrode comprises a plurality of inner electrodes, which are respectively interposed between the semiconductor patterns, and
the back-side gate contact is in direct contact with the lowermost one of the inner electrodes.

3. The semiconductor device of claim 2, wherein the lower power line is vertically overlapped with the channel pattern.

4. The semiconductor device of claim 2, further comprising a back-side active contact that penetrates the substrate and connects one of the source and drain patterns to the lower power line.

5. The semiconductor device of claim 4, wherein a portion of a side surface of the back-side active contact is in contact with a portion of a side surface of the back-side gate contact.

6. The semiconductor device of claim 2, wherein the back-side gate contact is in contact with one of the source and drain patterns.

7. The semiconductor device of claim 1, wherein the lower power line is configured to apply a power voltage or a ground voltage to the back-side gate contact.

8. The semiconductor device of claim 1, wherein the first and second transistors comprise first and second gate electrodes, respectively, and
the dummy gate electrode is spaced apart from the first and second gate electrodes by substantially the same distance.

9. The semiconductor device of claim 1, wherein the substrate is an insulating substrate.

10. The semiconductor device of claim 1, wherein the substrate including first and second active regions, which are spaced apart from each other in a first direction,
wherein the semiconductor device further comprises:
a first lower power line disposed in a lower portion of the substrate and overlapped with the first active region;
a second lower power line disposed in a lower portion of the substrate and overlapped with the second active region;
first and second inverters provided on the substrate and connected to each other in series; and
an isolation circuit provided between the first inverter and the second inverter,
wherein the isolation circuit comprises:
first source/drain patterns on the first active region;
a first dummy gate electrode provided between the first source/drain patterns and crossing the first active region;
second source/drain patterns on the second active region;
a second dummy gate electrode provided between the second source/drain patterns, crossing the second active region and spaced apart from the first dummy gate electrode in the first direction;
a first back-side gate contact penetrating the substrate and directly connected to the first lower power line and the first dummy gate electrode; and
a second back-side gate contact penetrating the substrate and directly connected to the second lower power line and the second dummy gate electrode.

11. The semiconductor device of claim 10, further comprising:
a first back-side active contact penetrating the substrate and directly connected to the first lower power line and at least one of the first source/drain patterns; and
a second back-side active contact penetrating the substrate and directly connected to the second lower power line and at least one of the second source/drain patterns.

12. The semiconductor device of claim 11, wherein a portion of a side surface of the first back-side gate contact is in contact with a portion of a side surface of the first back-side active contact, and
a portion of a side surface of the second back-side gate contact is in contact with a portion of a side surface of the second back-side active contact.

13. The semiconductor device of claim 10, wherein the first source/drain patterns and the first dummy gate electrode constitute a first isolation transistor,
the second source/drain patterns and the second dummy gate electrode constitute a second isolation transistor,
the first lower power line is configured to provide a power voltage to turn off the first isolation transistor, and
the second lower power line is configured to provide a ground voltage to turn off the second isolation transistor.

14. The semiconductor device of claim 13, wherein the first and second isolation transistors are connected in common to an output terminal of the first inverter.

15. The semiconductor device of claim 13, wherein the first source/drain patterns and the first dummy gate electrode of the first isolation transistor are connected in common to one of source/drain terminals of a p-channel metal-oxide-semiconductor (PMOS) transistor of the first or second inverter, and
the second source/drain patterns and the second dummy gate electrode of the second isolation transistor are connected in common to one of source/drain terminals of an n-channel metal-oxide semiconductor (NMOS) transistor of the first or second inverter.
